(19) Europäisches Patentamt
European Patent Office
Office européen des brevets

(11) EP 1 375 559 B1

# (12) EUROPÄISCHE PATENTSCHRIFT

(45) Veröffentlichungstag und Bekanntmachung des Hinweises auf die Patenterteilung:
**27.12.2006 Patentblatt 2006/52**

(51) Int Cl.:
*C08G 69/26* (2006.01) *C08G 73/22* (2006.01)
*C08G 69/32* (2006.01) *H01B 3/30* (2006.01)

(21) Anmeldenummer: **03013753.3**

(22) Anmeldetag: **17.06.2003**

## (54) Dielektrikum mit Sperrwirkung gegen Kupferdiffusion

Dielectrics with copper diffusion barrier

Diélectrique à barrière de diffusion contre le cuivre

(84) Benannte Vertragsstaaten:
**DE GB IE**

(30) Priorität: **27.06.2002 DE 10228770**

(43) Veröffentlichungstag der Anmeldung:
**02.01.2004 Patentblatt 2004/01**

(73) Patentinhaber: **Qimonda AG**
**81739 München (DE)**

(72) Erfinder:
- **Sezi, Recai**
**91341 Röttenbach (DE)**
- **Walter, Andreas**
**91349 Egloffstein (DE)**
- **Maltenberger, Anna**
**91359 Leutenbach (DE)**
- **Lowack, Klaus**
**91054 Erlangen (DE)**

(74) Vertreter: **Müller - Hoffmann & Partner Patentanwälte,**
**Innere Wiener Strasse 17**
**81667 München (DE)**

(56) Entgegenhaltungen:
**US-A- 4 611 053** **US-A- 5 973 202**

- **PATENT ABSTRACTS OF JAPAN vol. 2002, no. 10, 10. Oktober 2002 (2002-10-10) & JP 2002 174609 A (SUMITOMO BAKELITE CO LTD), 21. Juni 2002 (2002-06-21)**

EP 1 375 559 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft Poly-o-hydroxyamide, ein Verfahren zu deren Herstellung, Polybenzoxazole sowie ein Verfahren zu deren Herstellung, ein elektronisches Bauteil, welches die Polybenzoxazole als ein Dielektrikum enthält, sowie ein Verfahren zur Herstellung derartiger elektronischer Bauteile.

Um ein durch kapazitive Kopplung verursachtes Übersprechen von Signalen zu vermeiden, werden in Mikrochips benachbarte Leiterbahnen durch ein zwischen den Leiterbahnen angeordnetes Dielektrikum voneinander isoliert. Verbindungen, die als Dielektrikum eingesetzt werden sollen, müssen verschiedene Anforderungen erfüllen. So hängt die Signallaufzeit in Mikrochips sowohl vom Material der Leiterbahn ab, wie auch vom Dielektrikum, das zwischen den Leiterbahnen angeordnet ist. Je geringer die Dielektrizitätskonstante des Dielektrikums ist, um so geringer ist auch die Signallaufzeit. Die bisher verwendeten Dielektrika auf der Basis von Siliziumdioxid besitzen eine Dielektrizitätskonstante von ca. 4. Diese Materialien werden nach und nach durch organische Dielektrika ersetzt, die eine deutlich niedrigere Dielektrizitätskonstante aufweisen. Die Dielektrizitätskonstante dieser Materialien liegt meist unterhalb von 3.

In den gegenwärtig gebräuchlichen Mikrochips bestehen die Leiterbahnen bevorzugt aus Aluminium, AlCu oder AlCuSi. Mit zunehmender Integrationsdichte der Speicherchips geht man wegen seines im Vergleich zu Aluminium geringeren elektrischen Widerstandes auf Kupfer als Leiterbahnmaterial über. Kupfer erlaubt kürzere Signallaufzeiten und damit die Verringerung des Leiterbahnquerschnitts. Im Gegensatz zu den bisher gebräuchlichen Techniken, bei denen das Dielektrikum in den Gräben zwischen den Leiterbahnen eingefüllt wird, strukturiert man in der Kupfer-Damascene-Technik zuerst das Dielektrikum. Die dabei entstehenden Gräben werden zunächst mit Kupfer gefüllt und daraufhin überschüssiges Kupfer mechanisch abgeschliffen. Das Dielektrikum muss daher stabil gegenüber den zum Schleifen verwendeten Materialien sein und eine ausreichende Haftung auf dem Untergrund aufweisen, um während des mechanischen Schleifprozesses nicht abgelöst zu werden. Ferner müssen die Dielektrika auch eine ausreichende Stabilität in den folgenden Prozessschritten aufweisen, in welchen weitere Bauelemente der Mikrochips erzeugt werden. Dazu müssen diese beispielsweise eine ausreichende Temperaturstabilität aufweisen und dürfen auch bei Temperaturen von mehr als 400 °C keine Zersetzung erleiden. Ferner müssen die Dielektrika gegenüber Prozesschemikalien, wie Lösungsmitteln, Strippern, Basen, Säuren oder aggressiven Gasen, stabil sein. Weitere Anforderungen sind eine gute Löslichkeit und ausreichende Lagerstabilität der Vorstufen, aus welchen die Dielektrika erzeugt werden.

Um als Dielektrikum für Mikrochips geeignet zu sein, ist es sehr wichtig, dass das Metall der Leiterbahnen auch bei erhöhter Temperatur nicht in das Dielektrikum diffundiert. Während der Herstellung von Mikrochips werden Produktionsstufen durchlaufen, die eine Temperaturbelastung von bis zu 400 °C und darüber verursachen, wie zum Beispiel Oxidabscheidung, Kupfer-Annealing oder Wolframabscheidung aus der Gasphase. Um die Diffusion des Metalls in das Dielektrikum zu vermeiden, wird zwischen Dielektrikum und Metall eine Barriere vorgesehen. Derartige Barrieren bestehen beispielsweise aus Titannitrid, Siliziumnitrid, Siliziumcarbid oder Tantalnitrid. Die Barriere wirkt dabei weder als ein gutes Dielektrikum, noch als ein guter Leiter. Sie benötigt jedoch Platz, da eine gewisse Schichtdicke der Barriere erforderlich ist, um eine Diffusion des Metalls in das Dielektrikum wirksam zu unterdrücken. Mit zunehmender Integrationsdichte, das heißt abnehmender Breite der Leiterbahnen, nimmt der Anteil des Raumes, der von der Barriere eingenommen wird, relativ zur Breite der Leiterbahn deutlich zu. Bei einer Leiterbahnbreite von 100 nm und weniger kann die Barriere gegebenenfalls bis zu 10 % der zur Verfügung stehenden Breite beanspruchen. Eine weitere Miniaturisierung der Halbleiterbauelemente wird daher erschwert. Für eine weitere Miniaturisierung der Mikrochips muss daher die Breite der Barriere weiter verringert werden bzw. sollte diese im besten Fall ganz entfallen.

Polybenzoxazole (PBO) sind Polymere, die eine sehr hohe Wärmebeständigkeit aufweisen. Die Substanzen werden bereits zur Herstellung von Schutz- und Isolierschichten in Mikrochips verwendet. Polybenzoxazole können durch Zyklisierung aus Poly-o-hydroxyamiden hergestellt werden. Die Poly-o-hydroxyamide zeigen eine gute Löslichkeit in organischen Lösungsmitteln, sowie gute Filmbildungseigenschaften. Sie lassen sich mittels Schleudertechnik einfach auf elektronische Bauteile aufbringen. Bei einer Temperaturbehandlung, bei welcher das Poly-o-hydroxyamid zum Polybenzoxazol zyklisiert wird, erhält man ein Polymer, das die gewünschten Eigenschaften aufweist. Polybenzoxazole lassen sich auch direkt in ihrer zyklisierten Form verarbeiten. In der Regel bestehen jedoch in diesem Fall Schwierigkeiten mit der Löslichkeit des Polymers. Bausteine für Poly-o-hydroxyamide werden beispielsweise in der DE 100 11 608 beschrieben.

Weitere hochtemperaturstabile Isoliermaterialien sind beispielsweise aus der WO 97/10193, WO 91/09081 und WO 91/09087 sowie EP 23 662 und EP 264 678 bekannt. Bei diesen Materialien muss jedoch eine Barriere zwischen Leiterbahn und Dielektrikum vorgesehen werden, um eine Diffusion des Metalls in das Dielekrikum bei hohen Temperaturen zu vermeiden.

US-A-5 973 202 offenbart ein Verfahren zur Herstellung bestimmter Poly-o-hydroxyamide.

Aufgabe der Erfindung ist es daher, ein hochtemperaturstabiles Polymer für die Verwendung in Mikrochips zur Verfügung zu stellen, das die Herstellung feinerer Leiterbahnen in Mikrochips ermöglicht.

Die Aufgabe wird gelöst mit einem Poly-o-hydroxyamid der Formel I

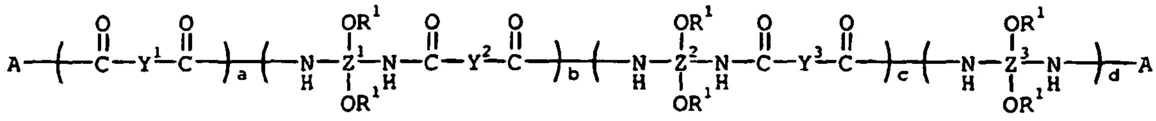

FORMEL I

wobei bedeutet:

$Y^2$ :

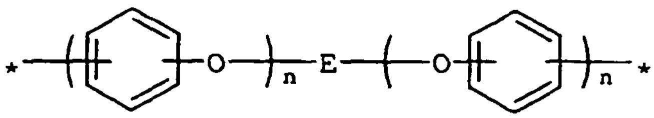

$Y^1$, $Y^3$: jeweils unabhängig, die gleiche Bedeutung wie $Y^2$, sowie

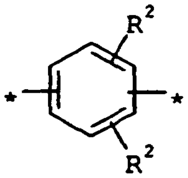
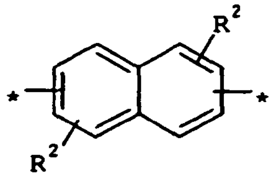
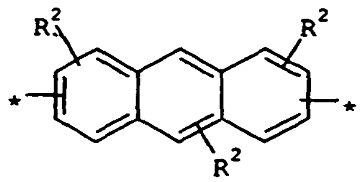

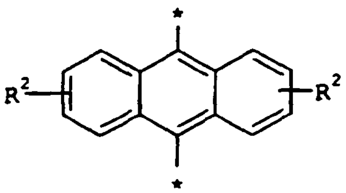
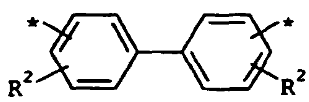
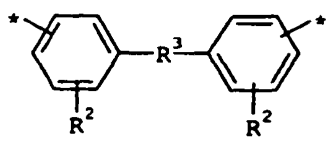

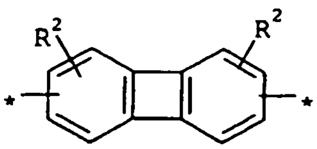
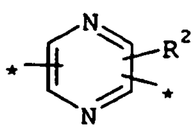
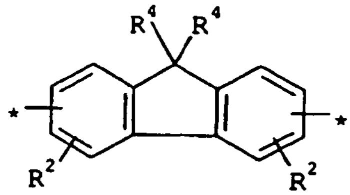

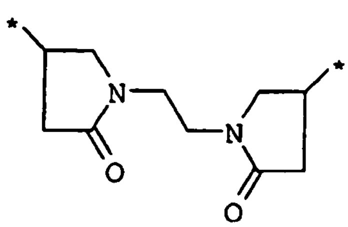
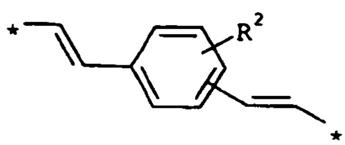
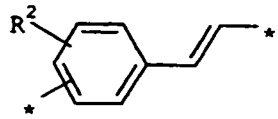

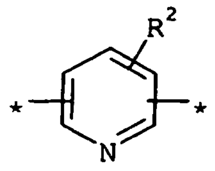 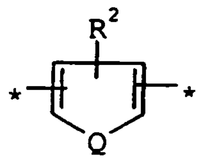 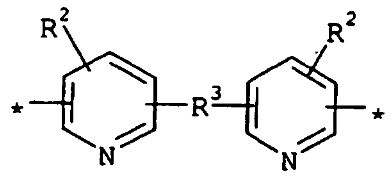 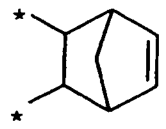

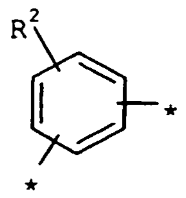 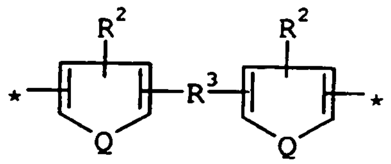 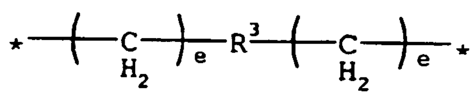

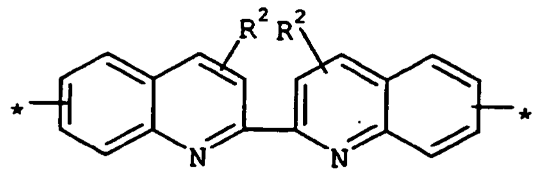 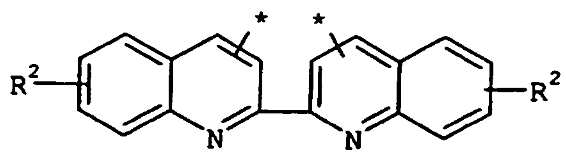

$Z^1$, $Z^2$, $Z^3$, jeweils unabhängig:

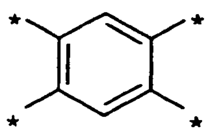 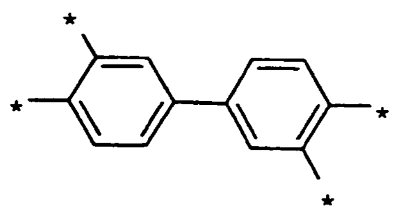 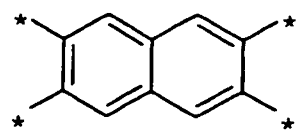

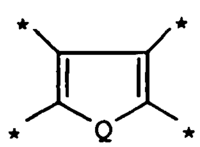 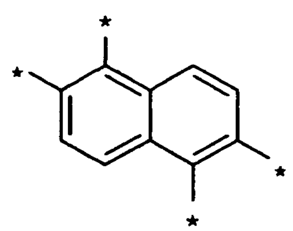 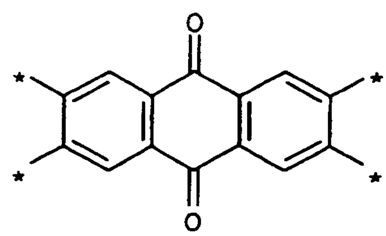

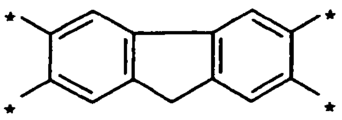
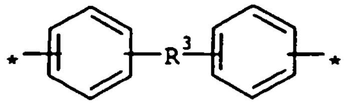
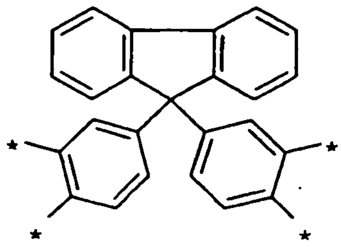

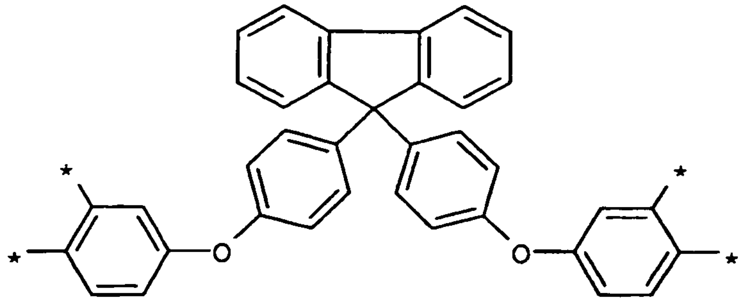
;

A: wenn a = 0 und/oder d = 1

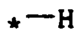
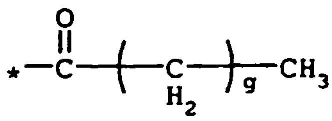
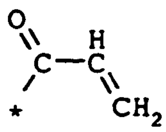
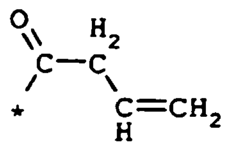

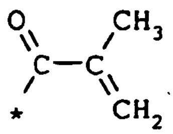
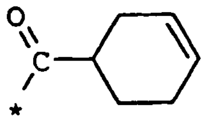
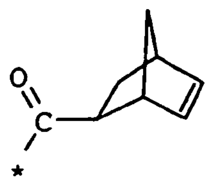
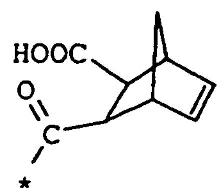

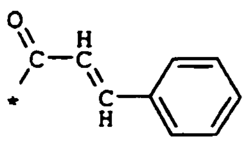
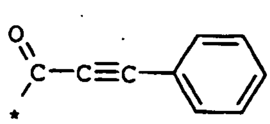
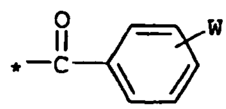
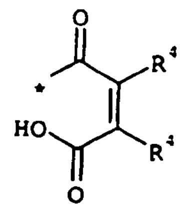

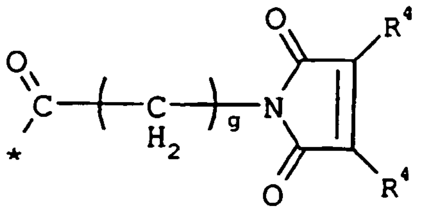 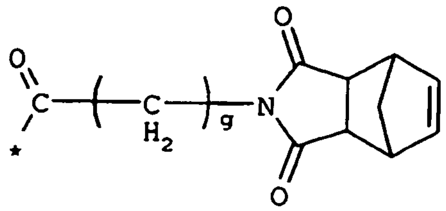

;.

wenn a = 1 und/oder d = 0

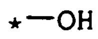 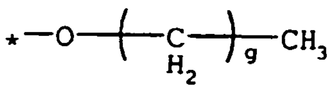 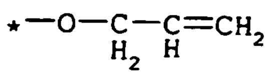

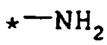 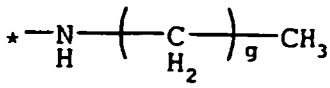 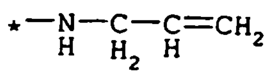

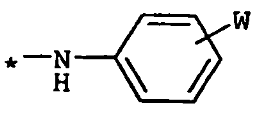 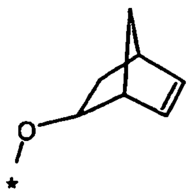 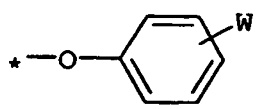

;

E:

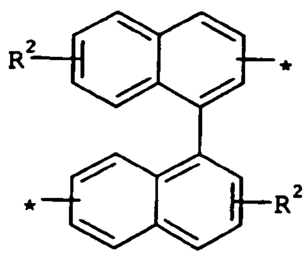 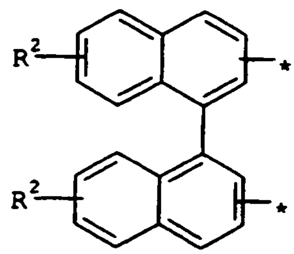 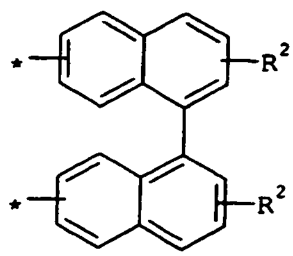

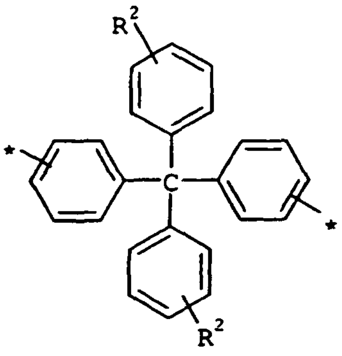

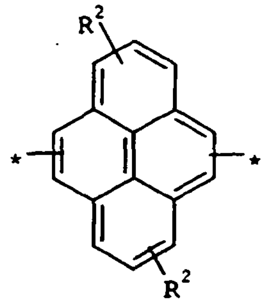

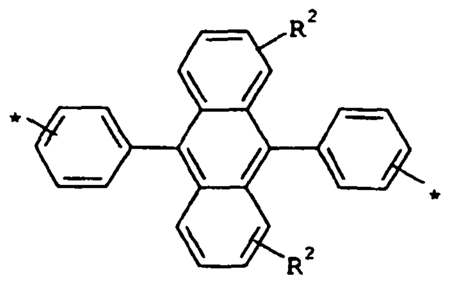

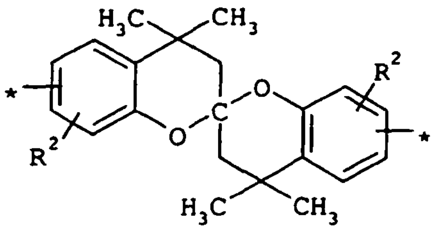

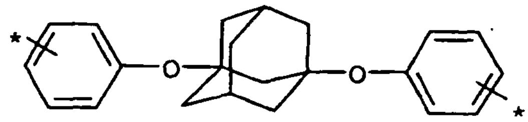

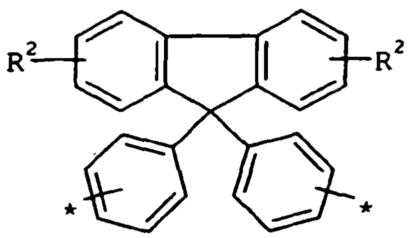

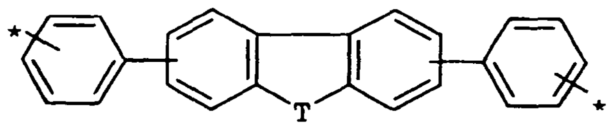

;

W:

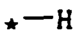

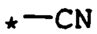

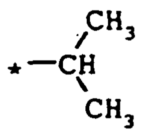

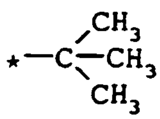

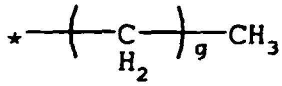

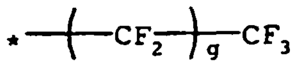

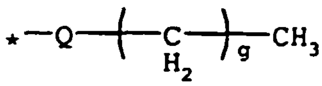

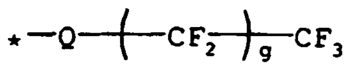

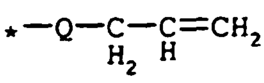

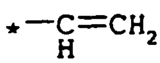

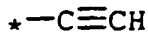

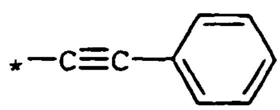

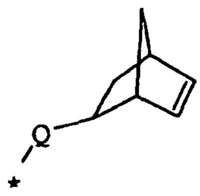 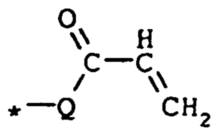 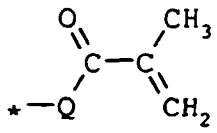 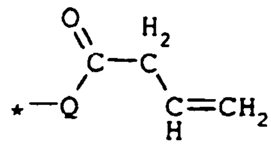

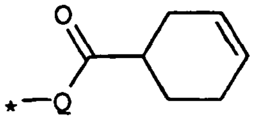 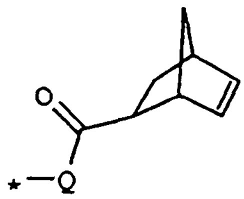 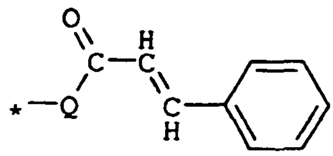

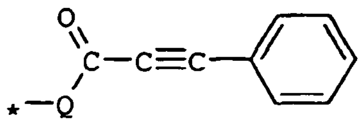 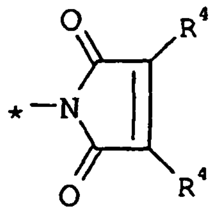 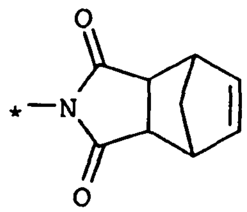

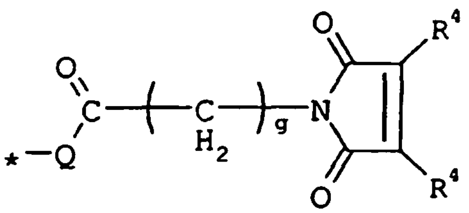 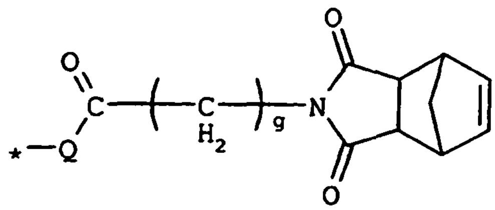

;

T:

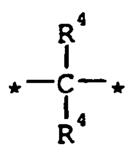 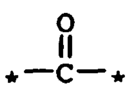 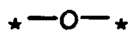 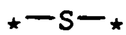 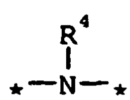

;

Q:

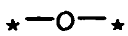 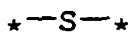 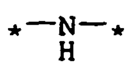

;

$R^1$:

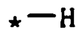
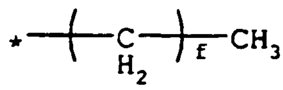
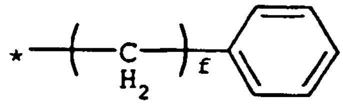

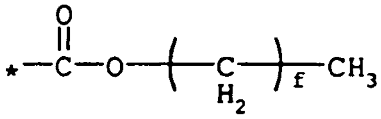
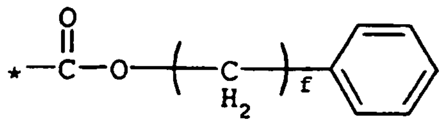
;

$R^2$: -H, $-CF_3$, -OH, -SH, -COOH, $-N(R^5)_2$, eine Alkylgruppe, eine Arylgruppe, eine Heteroarylgruppe, sowie

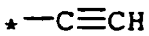
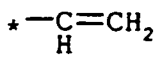
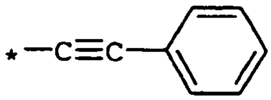
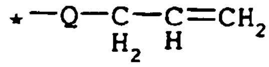

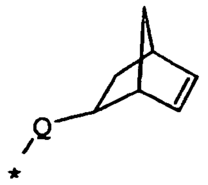
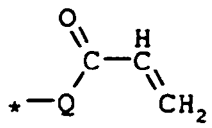
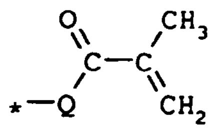
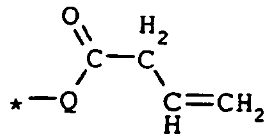

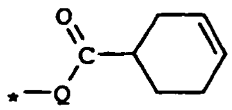
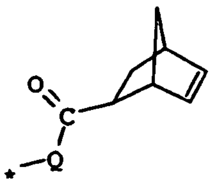
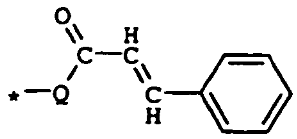
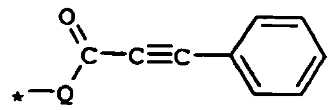

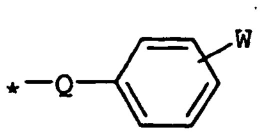
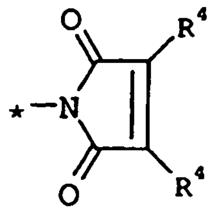
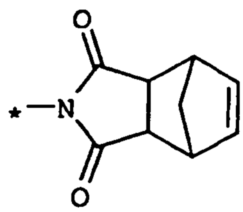

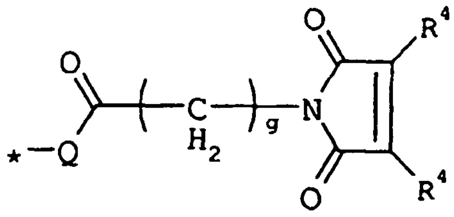
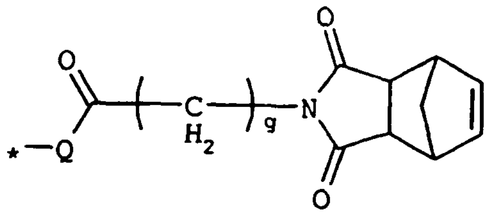
;

R$^3$:

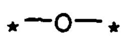
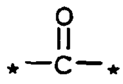
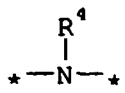
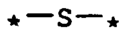
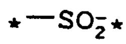
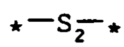
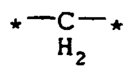

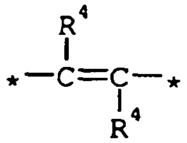
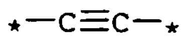
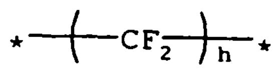
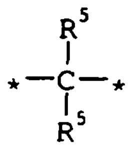

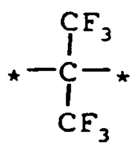
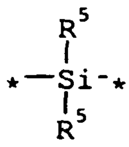
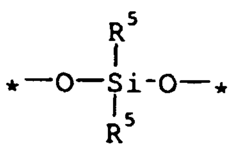
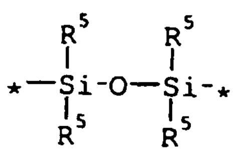

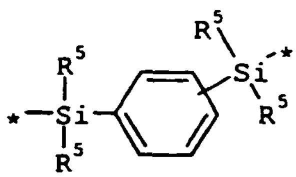
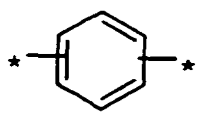
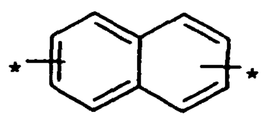
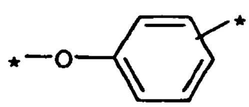

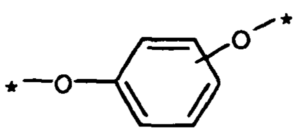
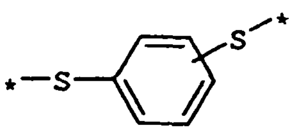
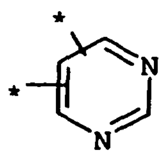
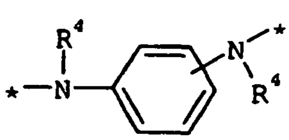

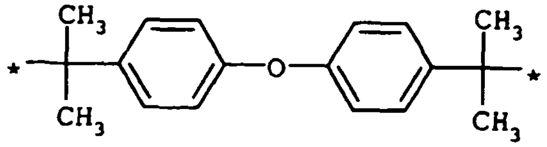 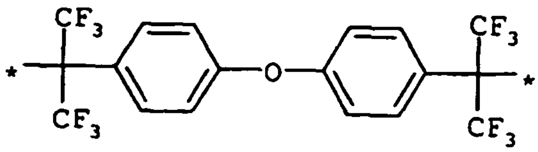

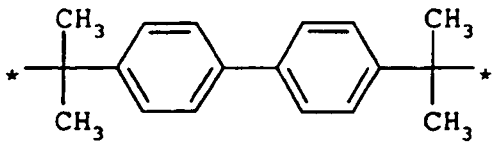 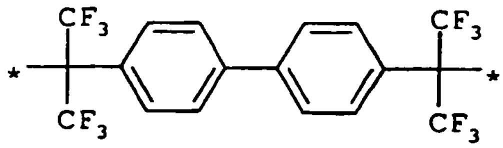 ;

$R^4$:

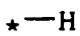 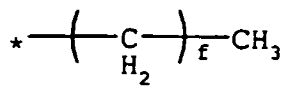 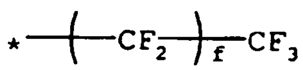

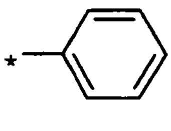 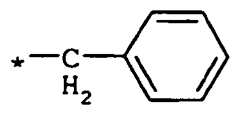 ;

$R^5$: einen Alkyl-, einen Aryl- oder einen Heteroarylrest;

a: 0 oder 1;
b: 1 - 200;
c: 0 - 200;
d: 0 oder 1;
e: 0 - 10;
f: 0 - 10;
g: 0 - 10;
h: 1 - 10;
n: 0 oder 1;

wobei wenn $R^3$ = $-CH_2-$, ist x = 0 - 10.

Die Poly-o-hydroxyamide der Formel I lösen sich in vielen organischen Lösungsmitteln, wie beispielsweise Aceton, Cyclohexanon, Diethylenglykolmono- bzw. Diethylether, N-Methylpyrrolidon, $\gamma$-Butyrolacton, Ethyllactat, Methoxypropylacetat, Tetrahydrofuran oder Essigsäureethylester. Sie lassen sich durch Schleuder-, Sprüh- oder Tauchtechniken sehr gut in einem gleichmäßigen Film auf einem Substrat auftragen. Nach Ver-Verdampfen des Lösungsmittels wird ein homogener Film erhalten, der eine gleichmäßige Schichtdicke aufweist, wobei auch in Gräben und Kontaktlöchern mit einem hohen Aspektverhältnis eine vollständige Füllung erreicht wird. Die Poly-o-hydroxyamide der Formel I lassen sich durch Erwärmen zu den entsprechenden Polybenzoxazole zyklisieren, wobei keine Blasen- oder Rissbildung beobachtet wird. Auch bei hohen Prozesstemperaturen von 400 °C oder darüber wird keine oder zumindest nur eine sehr geringe Diffusion von Metall aus den Leiterbahnen in angrenzende Bereiche des Dielektrikums beobachtet. Die üblicherweise zwischen Leiterbahn und Dielektrikum angeordnete Barriere kann daher entweder sehr dünn ausgeführt werden bzw. sogar gänzlich entfallen.

Die in der Formel I durch die Indizes b und c gekennzeichneten Wiederholungseinheiten können, sofern c > 0 ist, statistisch im Polymerstrang verteilt sein. Es ist aber auch möglich, das Poly-o-hydroxyamid der Formel I durch

Blockcopolymerisation herzustellen, so dass Abschnitte des Polymers nur aus jeweils einer durch die Indizes b und c bezeichneten Wiederholungseinheiten aufgebaut ist. Die Kettenlänge der Poly-o-hydroxyamide der Formel I kann durch die stöchiometrischen Verhältnisse der Ausgangsmaterialien sowie die Reaktionsbedingungen gesteuert werden, beispielsweise die Reaktionstemperatur, Verdünnung oder Zugabegeschwindigkeit der einzelnen Komponenten. Es versteht sich jedoch, dass das Polymer eine Molekülgewichtsverteilung aufweist, also jeweils Gemische aus Polymeren mit unterschiedlichem Molekülgewicht und damit unterschiedlichen Werten für die Indizes a, b, c, d vorliegen können. Bei der Herstellung der Poly-o-hydroxyamide der Formel I wird die Reaktion bevorzugt so geführt, dass eine enge Molekülgewichtsverteilung erreicht wird. Das Maximum der Molekülgewichtsverteilung wird dabei so eingestellt, dass es innerhalb der durch die Indizes a bis d gekennzeichneten Bereiche liegt. Innerhalb der Molekülgewichtsverteilung liegen vorzugsweise zumindest 90 % der Polymere innerhalb der durch die Indizes a bis d angegebenen Grenzen. Das Molekülgewicht der Poly-o-hydroxyamide der Formel I lässt sich durch übliche Methoden ermitteln, beispielsweise Gelpermeationschromatografie.

Das Substitutionsmuster der Gruppen $Z^1$, $Z^2$ und $Z^3$ wird so gewählt, dass jeweils ein aus einer -NH-Gruppe und einer $OR^1$-Gruppe gebildetes Paar in ortho-Stellung zueinander angeordnet sind. Dies ist erforderlich, um bei der Zyklisierung der Poly-o-hydroxyamide der Formel I eine Zyklisierung zu einem Oxazolring zu ermöglichen. Die Poly-o-hydroxyamide der Formel I können endständig eine Gruppe A tragen, die nach der Polymerisation über eine entsprechende aktivierte Verbindung endständig in das Polymer eingeführt wird. Geeignete Verbindungen sind beispielsweise Säurechloride, Alkylhalogenide oder Alkohole. Die zur Einführung der endständigen Gruppe A benötigte Vorstufe wird entsprechend zur Gruppe ausgewählt, die das Polymer nach der Polymerisation endständig trägt. Ist der Index a = 0 bzw. der Index d = 1, ist die endständige Gruppe A an eine NH-Gruppe gebunden. Als aktivierte Vorstufe eignet sich dann beispielsweise ein Säurechlorid. Ist der Index a = 1 bzw. der Index d = 0, ist die endständige Gruppe A an eine CO-Gruppe gebunden. Geeignete Reagenzien zur Einführung der endständigen Gruppe A sind dann beispielsweise Halogenide, Alkohole oder Amine.

Ist die Gruppe $R^2$ eine Alkylgruppe, so umfasst diese vorzugsweise 1 bis 10 Kohlenstoffatome. Die Alkylgruppe kann dabei linear oder verzweigt sein. Geeignete Gruppen sind beispielsweise eine Methylgruppe, eine Ethylgruppe, eine Propylgruppe oder eine Isopropylgruppe. Ist $R^2$ eine Arylgruppe, so umfasst diese bevorzugt 6 bis 20 Kohlenstoffatome, wobei das aromatische System auch durch Alkylgruppen substituiert sein kann. Beispiele für geeignete Gruppen sind die Phenylgruppe, die Methylphenylgruppe oder die Naphthylgruppe. Ist $R^2$ eine Heteroarylgruppe, so umfasst diese vorzugsweise 4 bis 20 Kohlenstoffatome, sowie 1 bis 4 Heteroatome. Als Heteroatome sind beispielsweise Stickstoff, Sauerstoff oder Schwefel geeignet.

Ist $R^5$ eine Alkylgruppe, so kann diese linear oder verzweigt sein und umfasst vorzugsweise 1 bis 10 Kohlenstoffatome. Ist $R^5$ eine Arylgruppe, so umfasst diese bevorzugt 6 bis 20 Kohlenstoffatome, wobei das aromatische System bevorzugt durch 6-gliedrige Ringe gebildet wird. Ist $R^5$ eine Heteroarylgruppe, so umfasst diese bevorzugt 4 bis 10 Kohlenstoffatome und 1 bis 4 Heteroatome. Als Heteroatome eignen sich auch hier Stickstoff, Sauerstoff oder Schwefel.

Die Filmqualität des mit dem Poly-o-hydroxyamid der Formel I wird unter anderem durch die Kettenlänge des Polymers beeinflusst. Besonders bevorzugt ist das Poly-o-hydroxyamid der Formel I so aufgebaut, dass der Index b Werte zwischen 5 und 50 annimmt und der Index c Werte zwischen 0 und 50. In einer besonderen Ausführungsform nimmt der Index c Werte im Bereich von 1 bis 50 an. In einer bevorzugten Ausführungsform umfasst das Poly-o-hydroxyamid der Formel I Etherbrücken. In diesem Fall nimmt der Index n im Strukturelement $Y^2$ den Wert 2 an.

Die aus dem Poly-o-hydroxyamid der Formel I erzeugten Polybenzoxazole weisen eine Dielektrizitätskonstante von weniger als 3 auf. Soll die Dielektrizitätskonstante noch weiter erniedrigt werden, so werden im Polybenzoxazol Poren vorgesehen. Dazu kann das Poly-o-hydroxyamid der Formel I weitere Wiederholungseinheiten umfassen, die thermisch labil sind und beim Erhitzen unter Zersetzung ein Gas freisetzen. Das Gas kann aus dem Polybenzoxazol herausdiffundieren, so dass ein Hohlraum im Polybenzoxazol ausgebildet wird.

Die thermisch labile Wiederholungseinheit wird bevorzugt als Block im Poly-o-hydroxyamid der Formel I vorgesehen. Dies kann beispielsweise erreicht werden, indem zunächst Oligomere aus den thermisch labilen Wiederholungseinheiten hergestellt werden und diese dann mit dem Poly-o-hydroxyamid der Formel I umgesetzt werden. Es ist aber auch möglich, zunächst ein Poly-o-hydroxyamid der Formel I durch Polymerisation herzustellen, und auf dieses dann die thermisch labilen Wiederholungseinheiten in einer weiteren Polymerisationsreaktion aufzupfropfen. Die Zersetzungstemperatur der thermisch labilen Wiederholungseinheiten sollte dabei so gewählt werden, dass sie unterhalb der Glastemperatur des Poly-o-hydroxyamids der Formel I liegt. Geeignete Wiederholungseinheiten, um die das Poly-o-hydroxyamid der Formel I ergänzt werden kann, um ein thermisch labiles Copolymer zu erhalten, leiten sich beispielsweise von Polypropylenoxid, Polymethylmethacrylat sowie aliphatischen Polycarbonaten, wie zum Beispiel Polypropylencarbonat und Polyethylencarbonat ab. Zusätzlich zu den genannten thermisch labilen Wiederholungseinheiten können auch andere Wiederholungseinheiten eingesetzt werden, sofern sie beim Erhitzen ein gasförmiges Produkt abspalten. Der Anteil der thermisch labilen Wiederholungseinheiten im Copolymer wird vorzugsweise zwischen 5 und 60 Gew.-% des Copolymers gewählt. Derartige Copolymere sind beispielsweise in der US 5,776,990 beschrieben.

Eine Porenbildung kann auch erreicht werden, indem dem Poly-o-hydroxyamid der Formel I ein geeignetes Porogen zugegeben wird, das sich beim Erhitzen zersetzt, wobei gasförmige Produkte freigesetzt werden. Geeignete Porogene sind z.B. Zitronensäure, Äpfelsäure oder Malonsäure.

Wie bereits erwähnt, weisen die aus den Poly-o-hydroxyamiden der Formel I durch Zyklisierung erhaltenen Polybenzoxazole vorteilhafte Eigenschaften auf. Die Haftung des aus dem Poly-o-hydroxyamid der Formel I hergestellten Polybenzoxazols auf für die Mikrochip-Technologie relevanten Oberflächen, wie Silizium, Siliziumcarbid, Siliziumcarbonitrid, Siliziumnitrid, Siliziumoxid, Titan, Tantal, Titannitrid, Tantalnitrid oder Siliziumoxinitrid ist sehr gut. Ferner weisen die Polybenzoxazole eine hohe Beständigkeit gegenüber Chemikalien auf, wie sie bei der Herstellung von Mikrochips verwendet werden, wie Lösungsmitteln, Strippern, Basen, Säuren oder aggressiven Gasen. Die Polymermaterialien eignen sich daher sehr gut für mikroelektronische Anwendungen. Außerdem eignen sich die Materialien auch hervorragend für die Kupfer-Damascene-Technik. Während des Schleifprozesses von Kupfer treten keine nachteiligen Effekte, wie Ablösungen, Riss- oder Blasenbildungen auf. Die erfindungsgemäßen Polybenzoxazole hemmen überraschenderweise die Diffusion im Dielektrikum. Neben der elektrischen Isolierfunktion können sie deswegen auch als Diffusionssperre für Kupfer verwendet werden. Damit kann auf eine Barriere zwischen Dielektrikum und Leiterbahn verzichtet werden, bzw. kann diese deutlich dünner ausgeführt werden. Durch den geringeren Platzbedarf ermöglicht dies eine Erhöhung der Integrationsdichte. Sofern auf die Barriere gänzlich verzichtet werden kann, ergibt sich durch die Verwendung der erfindungsgemäßen Polybenzoxazole ferner eine Erniedrigung der Herstellungskosten der Mikrochips, da der Schritt für die Herstellung der Barriere entfällt.

Die Poly-o-hydroxyamide der Formel I werden aus Bis-o-aminophenolen und Dicarbonsäuren bzw. ihren Derivaten hergestellt. Gegenstand der Erfindung ist daher auch ein Verfahren zur Herstellung von Poly-o-hydroxyamiden der Formel I, wobei zumindest ein Monomer der Formel II

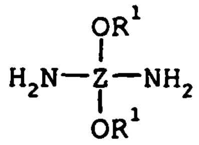

Formel II

wobei Z steht für $Z^1$, $Z^2$ oder $Z^3$, und $Z^1$, $Z^2$, $Z^3$ sowie $R^1$ die oben angegebene Bedeutung aufweisen, mit zumindest einer Dicarbonsäure oder einem aktivierten Dicarbonsäurederivat der Formel III umgesetzt wird,

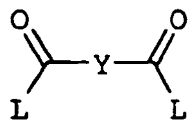

Formel III

wobei 1 für eine Hydroxygruppe oder eine aktivierende Gruppe steht und Y für $Y^1$, $Y^2$ oder $Y^3$ steht, und $Y^1$, $Y^2$, $Y^3$ die oben angegebene Bedeutung aufweisen.

Als aktivierende Gruppe für die Dicarbonsäurederivate der Formel III können zum Beispiel Säurechloride oder aktivierte Ester, zum Beispiel Sulfonsäureester verwendet werden. Die Umsetzung der Monomere der Formel II und der Dicarbonsäuren der Formel III kann jedoch auch in Gegenwart einer die Dicarbonsäure aktivierenden Verbindung erfolgen, wie zum Beispiel Carbonyldiimidazol oder Dicyclohexylcarbodiimid. Im Prinzip eignen sich alle Reagenzien, die das bei der Reaktion entstandene Wasser an sich binden. Für die Herstellung der Poly-o-hydroxyamide der Formel I werden die Monomeren der Formel II und die Dicarbonsäuren bzw. gegebenenfalls die Dicarbonsäurederivate der Formel III in einem organischen Lösungsmittel bei -20 bis 150 °C innerhalb von 5 bis 20 Stunden zur Reaktion gebracht. Bei Bedarf können Endgruppen des Polymers mit einem geeigneten Reagenz blockiert werden, um so die endständigen Gruppen A einzuführen. Geeignete Reagenzien sind bereits bei der Erläuterung der Verbindung der Formel I beschrieben worden. Das nach der Reaktion entstandene Poly-o-hydroxyamid der Formel I wird durch Zutropfen der Reaktionslösung in ein Fällungsmittel gefällt, gewaschen und getrocknet. Geeignete Fällungsmittel sind Wasser, sowie Alkohole, wie

Isopropanol, Butanol oder Ethanol. Es können auch Mischungen dieser Fällmittel verwendet werden. Geeignet kann das Fällungsmittel auch von 0,1 % bis zu 10 % Ammoniak enthalten. Das ausgefallene Polymer kann nach Filtration und Trocknung unmittelbar weiterverarbeitet werden und zum Beispiel für den Auftrag auf ein Halbleitersubstrat in einem der weiter oben genannten Lösungsmittel gelöst werden.

Die Polymerisation zum Poly-o-hydroxyamid der Formel I kann in Gegenwart einer Base durchgeführt werden, um frei werdende Säure abzufangen. Geeignete basische Säurefänger sind beispielsweise Pyridin, Triethylamin, Diazabicyclooctan oder Polyvinylpyridin. Es können aber auch andere basische Säurefänger verwendet werden. Insbesondere bevorzugt werden Verbindungen, die im für die Synthese verwendeten Lösungsmittel, wie zum Beispiel N-Methylpyrrolidon, und im Fällungsmittel, zum Beispiel Wasser- oder Wasser-Alkohol-Mischungen, gut löslich sind, oder solche, die im Lösungsmittel vollkommen unlöslich sind, wie zum Beispiel vernetztes Polyvinylpyridin. Die Säurefänger lassen sich dann bei der Aufarbeitung des Reaktionsproduktes leicht vom entstandenen Poly-o-hydroxyamid der Formel I abtrennen.

Besonders geeignete Lösungsmittel für die Polymersynthese sind γ-Butyrolacton, Tetrahydrofuran, N-Methylpyrrolidon und Dimethylacetamid. An sich kann jedoch jedes Lösungsmittel verwendet werden, in dem die Ausgangskomponenten gut löslich sind.

Gegenstand der Erfindung ist ferner ein Verfahren zur Herstellung der beschriebenen Polybenzoxazole, wobei Poly-o-hydroxyamide der Formel I erhitzt werden. Beim Erhitzen erfolgt unter Abspaltung eines kleinen Moleküls, im Allgemeinen Wasser, die Ausbildung eines Oxazolrings, wobei die erfindungsgemäßen Polybenzoxazole erhalten werden. Der bei der Zyklisierung von Poly-o-hydroxyamiden der Formel I zu Polybenzoxazolen ablaufende Mechanismus ist im Folgenden schematisch dargestellt:

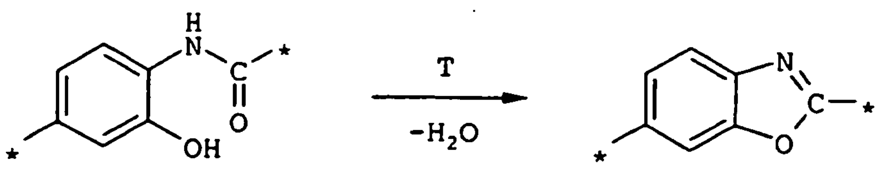


Beim Erhitzen zyklisiert das o-Hydroxyamid zum Oxazol, wobei Wasser freigesetzt wird.

Das mit dem erfindungsgemäßen Verfahren hergestellte Polybenzoxazol besitzt eine niedrige Dielektrizitätskonstante von k ≦ 3,0 und es haftet sehr gut an den für die Chiptechnologie relevanten Oberflächen, wie Silizium, Siliziumcarbid, Siliziumcarbonitrid, Siliziumnitrid, Siliziumoxid, Titan, Tantal, Titannitrid, Tantalnitrid oder Siliziumoxynitrid.

Gegenstand der Erfindung ist daher auch ein elektronisches Bauteil, welches das oben beschriebene Polybenzoxazol enthält. Das Polybenzoxazol kann zum Beispiel als Dielektrikum zwischen Leiterbahnen oder Leiterbahnebenen angeordnet sein oder auch als Pufferschicht zwischen Mikrochip und einem diesen umgebenden Gehäuse.

Die erfindungsgemäßen Dielektrika eignen sich hervorragend für die Kupfer-Damascene-Technik. Während des Schleifprozesses treten keine nachteiligen Effekte, wie Ablösungen, Riss- oder Blasenbildungen auf.

Gegenstand der Erfindung ist daher auch ein Verfahren zur Herstellung eines elektronischen Bauteils, wobei zunächst eine Lösung des Poly-o-hydroxyamids der Formel I in einem Lösungsmittel hergestellt wird. Die Lösung wird auf ein Substrat aufgebracht und das Lösungsmittel verdampft, so dass ein Film erhalten wird. Der Film wird anschließend erhitzt, um das Poly-o-hydroxyamid zu zyklisieren und in das Polybenzoxazol der Formel III zu überführen. Der Film wird dann strukturiert, um eine Resiststruktur zu erhalten, welche Gräben und/oder Kontaktlöcher aufweist. Auf der Resiststruktur wird anschließend ein leitendes Material abgeschieden, beispielsweise Kupfer, so dass die Gräben und/oder Kontaktlöcher mit dem leitenden Material ausgefüllt sind. Abschließend wird überschüssiges leitendes Material entfernt, beispielsweise durch chemisch-mechanisches Planarisieren (CMP).

Zum Strukturieren des Polybenzoxazolfilms können beispielsweise lithografische Verfahren verwendet werden, wobei eine ätzresistente Maske auf dem Film erzeugt wird. Die Struktur der Maske wird anschließend durch Ätzen in den Film aus dem erfindungsgemäßen Polybenzoxazol übertragen. Als leitendes Material wird vorzugsweise Kupfer verwendet. Zwischen Dielektrikum und leitendem Material kann eine Barriere vorgesehen werden. Als Material für die Barriere eignet sich beispielsweise die bereits weiter oben genannten Materialien. Der Mikrochip wird anschließend in üblicher Weise fertiggestellt.

Weiter betrifft die Erfindung ein Verfahren zur Herstellung eines elektronischen Bauteils, wobei zunächst eine Lösung eines oben beschriebenen Poly-o-hydroxyamids der Formel I in einem Lösungsmittel hergestellt wird. Die Lösung wird anschließend auf ein Substrat aufgebracht, welches auf seiner Oberfläche bereits metallische Strukturen aufweist, zwischen denen Gräben angeordnet sind. Derartige Strukturen sind beispielsweise Leiterbahnen. Das Lösungsmittel

wird verdampft, so dass die Gräben mit dem Poly-o-hydroxyamid der Formel I ausgefüllt sind. Zuletzt wird das Substrat erhitzt, um das Poly-o-hydroxyamid der Formel I zum Polybenzoxazol zu zyklisieren. Der Mikrochip wird anschließend in üblicher Weise fertiggestellt.

Die Haftung der Poly-o-hydroxyamide der Formel I auf in der Mikroelektronik relevanten Oberflächen, wie zum Beispiel Silizium, Siliziumoxid, Siliziumnitrid, Tantalnitrid, Glas oder Quarz kann durch die Zugabe von Haftvermittlern verbessert werden.

Die Erfindung wird anhand von Beispielen und unter Bezugnahme auf die beigefügten Figuren näher erläutert. Dabei zeigt:

Fig. 1: eine schematische Darstellung des Versuchsaufbaus zur Bestimmung der Dielektrizitätskonstante;

Fig. 2 eine Schattenmaske, wie sie in den Beispielen 28 bis 33 zur Herstellung von Elektroden verwendet wird.

Verwendete Chemikalien:

Bisaminophenole:

9, 9'-Bis-(4-((3-hydroxy-4-amino)phenyloxy)phenyl)fluoren-(Bisaminophenol 1)

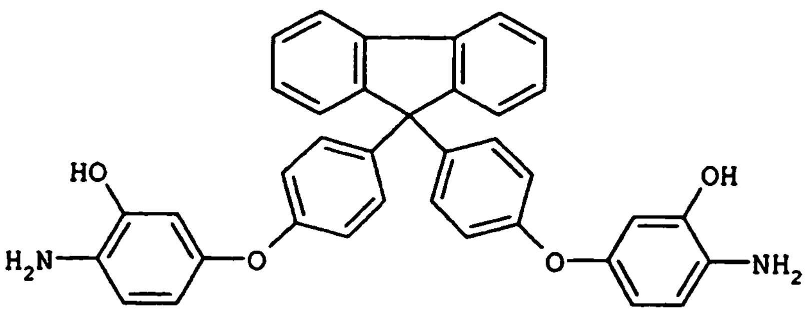

2,2-Bis-(3-amino-4-hydroxyphenyl)-hexafluoropropan - (Bisaminophenol 2)

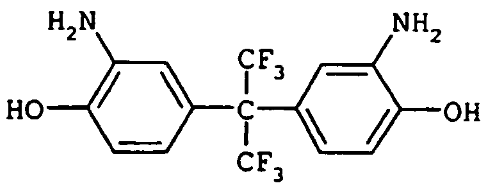

3,3'-Diamino-4,4'-dihydroxy-biphenyl- (Bisaminophenol 3)

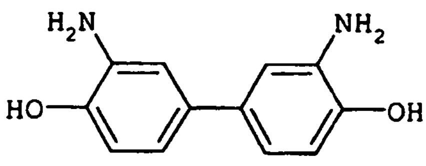

2,2-Bis-(3-amino-4-hydroxyphenyl)-sulfon - (Bisaminophenol 4)

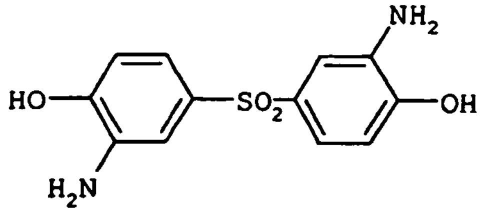

Dicarbonsäurechloride:

9,9'-Bis-(4-(4-chlorocarbonyl)-phenyloxy)-phenylfluoren - Dicarbonsäurechlorid 1

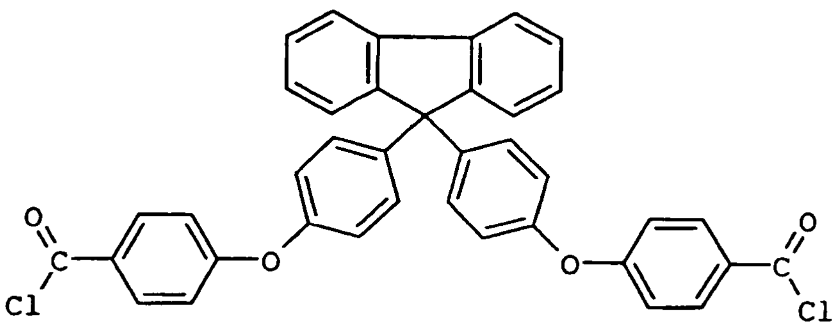

4,4'-Di-(4-(chlorocarbonyl)phenyloxy)-tetraphenylmethan- Dicarbonsäurechlorid 2

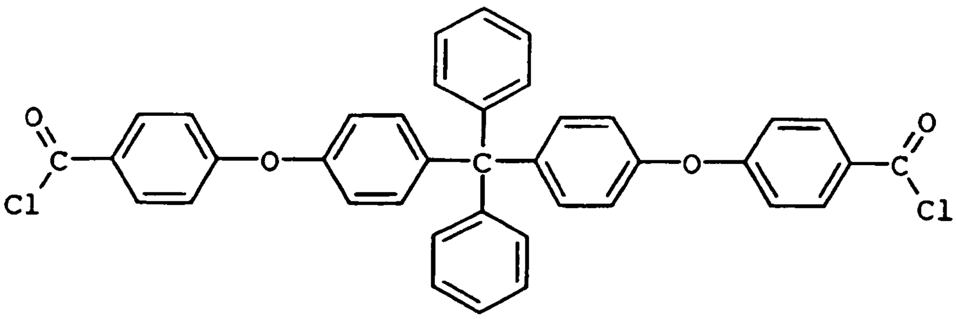

2,2'-Di-(4-(chlorocarbonyl)phenyloxy)-1,1'-binaphthyl- Dicarbonsäurechlorid 3

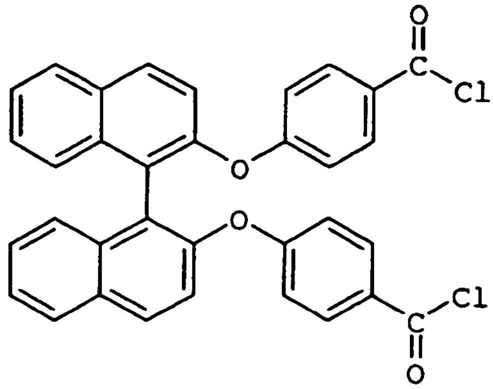

2,7-Di-tert-butyl-pyren-4,9-dicarbonsäurechlorid - (Dicarbonsäurechlorid 4)

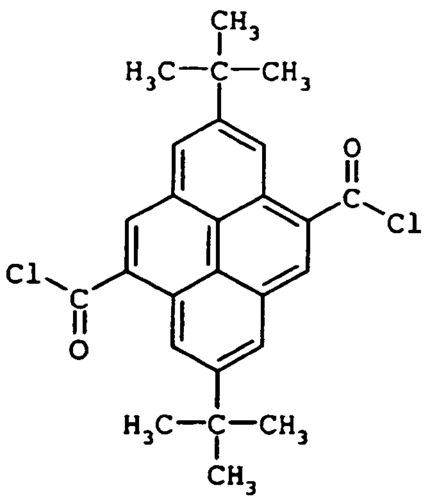

Diphenylether-4,4'-dicarbonsäurechlorid- (Dicarbonsäurechlorid 5)

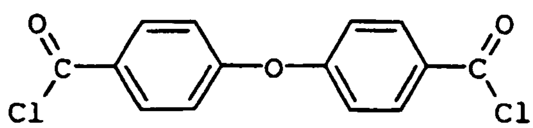

Terephthalsäuredichlorid - (Dicarbonsäurechlorid 6)

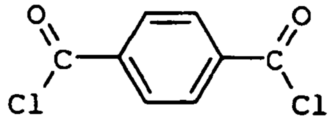

Diphenylethin-4,4'-dicarbonsäure chlorid-(Dicarbonsäurechlorid 7)

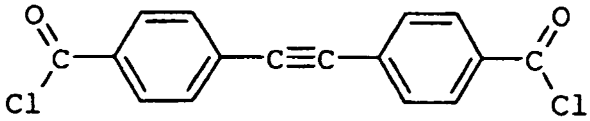

Endcap:

Methacrylsäurechlorid - (Endcap 1)

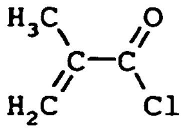

5-Norbornen-2-carbonsäurechlorid - (Endcap 2)

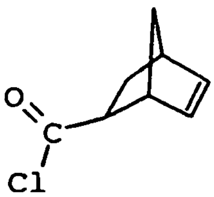

5-Norbornen-2,3-dicarbonsäureanhydrid - (Endcap 3)

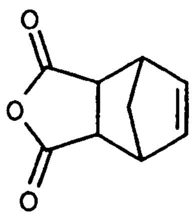

Anilin - (Endcap 4)

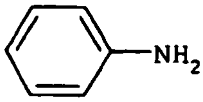

Beispiel 1: Synthese von Polymer 1

56,42 g (0,1 mol) Bisaminophenol 1 werden in 400 ml dest. N-Methylpyrrolidon (NMP) gelöst. Zu dieser Lösung wird bei 10 °C unter Rühren eine Lösung von 59,48 g (0,095 mol) Dicarbonsäurechlorid 1 gelöst in 400 ml dest. NMP zugetropft. Es wird noch 1 Stunde bei 10 °C und anschließend 1 Stunde bei 20 °C gerührt. Nach erneutem Kühlen auf 10 °C wird zur Reaktionsmischung 1,64 g (0,01 mol) Endcap 3 gelöst in 50 ml dest. γ-Butyrolacton (γ-BL) zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 30 ml dest. γ-BL versetzt, auf Raumtemperatur erwärmt und 2 Stunden gerührt.

Zur Isolierung des Polymers wird die Reaktionsmischung filtriert und das Filtrat in ein Gemisch aus 1 l vollentsalztem (VE) Wasser und 200 ml Isopropanol unter Rühren eingetropft, wobei während des Eintropfens noch weitere 3 l VE Wasser zugegeben werden. Das ausgefällte Polymer wird abgesaugt und mit 2 l kaltem VE Wasser gewaschen. Nach dem Absaugen wird das Polymer zweimal 1 Stunde bei Raumtemperatur in je 2,5 l einer 3 %-igen Ammoniaklösung gerührt und anschließend abgesaugt. Das Polymer wird mit VE Wasser neutral gewaschen, abfiltriert und 72 Stunden bei 50 °C / 10 mbar getrocknet.

Das auf diese Weise hergestellte Polymer ist in Lösungsmitteln wie NMP, γ-BL, Cyclohexanon, Cyclopentanon oder Gemische davon gut löslich.

Beispiel 2: Synthese von Polymer 2

53,6 g (0,095 mol) Bisaminophenol 1 werden in 400 ml dest. NMP gelöst. Zu dieser Lösung wird bei 10 °C unter Rühren eine Lösung von 62,8 g (0,1 mol) Dicarbonsäurechlorid 2 in 400 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 0,93 g (0,01 mol) Endcap 4 gelöst in 10 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 80 ml dest. γ-BL versetzt, auf Raumtemperatur erwärmt und 2 Stunden gerührt.

Die Isolierung und Aufarbeitung des Polymers 2 erfolgte analog Beispiel 1.

Beispiel 3: Synthese von Polymer 3

18,3 g (0,05 mol) Bisaminophenol 2 werden in 200 ml dest. NMP gelöst. Zu dieser Lösung wird bei 10 °C unter Rühren eine Lösung von 16,86 g (0,03 mol) Dicarbonsäurechlorid 3 und 7,67 g (0,0175 mol) Dicarbonsäurechlorid 4 in 250 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 0,52 g (0,005 mol) Endcap 1 gelöst in 20 ml dest. γ-BL zugetropft, 1 Stunde bei 10 °C und anschließend 1 Stunde bei 20 °C gerührt. Nach Kühlen auf 10 °C wird die Reaktionsmischung mit 9,48 g (0,12 mol) Pyridin gelöst in 30 ml dest. γ-BL versetzt, auf Raumtemperatur erwärmt und 2 Stunden gerührt.

Die Isolierung und Aufarbeitung des Polymers 3 erfolgte analog Beispiel 1.

Beispiel 4: Synthese von Polymer 4

34,78 g (0,095 mol) Bisaminophenol 2 werden in 200 ml dest. NMP gelöst. Zu dieser Lösung wird bei 10 °C unter Rühren eine Lösung von 31,3 g (0,05 mol) Dicarbonsäurechlorid 1 und 14,7 g (0,05 mol) Dicarbonsäurechlorid 5 in 200 ml dest. γ-BL zugetropft. Es wird noch 1 Stunde bei 10 °C und anschließend 1 Stunde bei 20 °C gerührt. Nach Kühlen auf 10 °C wird die Reaktionsmischung mit 11,85 g (0,15 mol) Pyridin gelöst in 50 ml dest. γ-BL versetzt, auf Raumtemperatur erwärmt und 2 Stunden gerührt.

Die Isolierung und Aufarbeitung des Polymers 4 erfolgte analog Beispiel 1.

Beispiel 5: Synthese von Polymer 5

10,8 g (0,05 mol) Bisaminophenol 3 werden in 200 ml dest. NMP gelöst. Zu dieser Lösung wird bei 10 °C unter Rühren eine Lösung von 12,04 g (0,0275 mol) Dicarbonsäurechlorid 4 in 100 ml dest. γ-BL zugetropft. Es wird noch 1 Stunde bei 10 °C und anschließend 1 Stunde bei 20 °C gerührt. Es wird auf 10 °C abgekühlt und 4,04 g (0,02 mol) Dicarbonsäurechlorid 6 gelöst in 80 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 0,78 g (0,005 mol) Endcap 2 gelöst in 20 ml dest. γ-BL zugetropft, 1 Stunde bei 10 °C und anschließend 1 Stunde bei 20 °C gerührt. Nach Kühlen auf 10 °C wird die Reaktionsmischung mit 11,85 g (0,15 mol) Pyridin gelöst in 50 ml dest. γ-BL versetzt, auf Raumtemperatur erwärmt und 2 Stunden gerührt.

Die Isolierung und Aufarbeitung des Polymers 5 erfolgte analog Beispiel 1.

Beispiel 6: Synthese des Polymers 6

26,6 g (0,095 mol) Bisaminophenol 4 werden in 300 ml dest. NMP gelöst. Zu dieser Lösung wird bei 10 °C unter Rühren eine Lösung von 33,72 g (0,06 mol) Dicarbonsäurechlorid 3 in 150 ml dest. NMP zugetropft. Es wird noch 1 Stunde bei 10 °C und anschließend 1 Stunde bei 20 °C gerührt. Es wird auf 10 °C abgekühlt und 12,08 g (0,04 mol) Dicarbonsäurechlorid 7 gelöst in 100 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 0,93 g (0,01 mol) Endcap 4 gelöst in 10 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 80 ml dest. γ-BL versetzt, auf Raumtemperatur erwärmt und 2 Stunden gerührt.

Die Isolierung und Aufarbeitung des Polymers 6 erfolgte analog Beispiel 1.

Beispiel 7: Synthese des Polymers 7

18,3 g (0,05 mol) Bisaminophenol 2 und 14,0 g (0,05 mol) Bisaminophenol 4 werden in 300 ml dest. NMP gelöst. Zu dieser Lösung wird bei 10 °C unter Rühren eine Lösung von 59,48 g (0,095 mol) Dicarbonsäurechlorid 1 in 300 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 1,64 g (0,01 mol) Endcap 3 gelöst in 20 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 50 ml dest. γ-BL versetzt, auf Raumtemperatur erwärmt und 2 Stunden gerührt.

Die Isolierung und Aufarbeitung des Polymers 7 erfolgte analog Beispiel 1.

Beispiel 8: Synthese des Polymers 8

21,96 g (0,06 mol) Bisaminophenol 2 und 8,64 g (0,04 mol) Bisaminophenol 3 werden in 300 ml dest. NMP gelöst. Zu dieser Lösung wird bei 10 °C unter Rühren eine Lösung von 28,1 g (0,05 mol) Dicarbonsäurechlorid 3 und 13,23 g (0,045 mol) Dicarbonsäurechlorid 5 gelöst in 350 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 1,56 g (0,01 mol) Endcap 2 gelöst in 50 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 50 ml dest. γ-BL versetzt, auf Raumtemperatur erwärmt und 2 Stunden gerührt.

Die Isolierung und Aufarbeitung des Polymers 8 erfolgte analog Beispiel 1.

Beispiel 9: Synthese des Polymers 9

39,49 g (0,07 mol) Bisaminophenol 1 und 8,4 g (0,03 mol) Bisaminophenol 4 werden in 300 ml dest. NMP gelöst. Zu dieser Lösung wird bei 10 °C unter Rühren eine Lösung von 37,56 g (0,06 mol) Dicarbonsäurechlorid 1 und 21,98 g (0,035 mol) Dicarbonsäurechlorid 2 in 350 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 1,56 g (0,01 mol) Endcap 2 gelöst in 15 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 80 ml dest. γ-BL versetzt, auf Raumtemperatur erwärmt und 2 Stunden gerührt.

Die Isolierung und Aufarbeitung des Polymers 9 erfolgte analog Beispiel 1.

Beispiel 10: Synthese des Polymers 10

12,96 g (0,06 mol) Bisaminophenol 3 werden in 150 ml dest. NMP gelöst. Zu dieser Lösung wird bei 10 °C unter Rühren eine Lösung von 34,43 g (0,055 mol) Dicarbonsäurechlorid 1 in 200 ml dest. γ-BL zugetropft. Es wird noch 1 Stunde bei 10 °C und anschließend 1 Stunde bei 20 °C gerührt. Es wird auf 10 °C abgekühlt und 11,2 g (0,04 mol) Bisaminophenol 4 gelöst in 100 ml dest. NMP zugetropft. Es wird noch 1 Stunde bei 10 °C und anschließend 1 Stunde bei 20 °C gerührt. Es wird wieder auf 10 °C abgekühlt und 11,76 g (0,04 mol) Dicarbonsäurechlorid 5 gelöst in 150 ml dest. γ-BL zugetropft. Es wird noch 1 Stunde bei 10 °C und anschließend 1 Stunde bei 20 °C gerührt. Nach erneutem Kühlen auf 10 °C wird zur Reaktionsmischung 1,04 g (0,01 mol) Endcap 1 gelöst in 20 ml dest. γ-BL zugetropft, 1 Stunde bei 10 °C und anschließend 1 Stunde bei 20 °C gerührt. Nach Kühlen auf 10 °C wird die Reaktionsmischung mit 19,76 g (0,25 mol) Pyridin gelöst in 50 ml dest. γ-BL versetzt, auf Raumtemperatur erwärmt und 2 Stunden gerührt.
Die Isolierung und Aufarbeitung des Polymers 10 erfolgte analog Beispiel 1.

Beispiel 11: Bestimmung der Thermostabilitäten

Alle dargestellten Polymere zeigen thermische Stabilitäten von > 490 °C nach TGA-Untersuchungen (Gerät: STA 1500 der Firma Rheometric Scientific, Aufheizrate: 5K/min, Schutzgas: Argon). Der isotherme Masseverlust pro Stunde (bei 425 °C) beträgt < 0,6%.
Damit erfüllen die dargestellten Polymere die Anforderungen für die eingangs angegebenen Applikationen.

Beispiel 12: Herstellung von Polymerlösungen

25 g der in den Beispielen 1 bis 10 dargestellten Polymere werden in 75 g dest. NMP (VLSI-Selectipur®) oder dest. γ-BL (VLSI-Selectipur®) gelöst. Der Lösevorgang erfolgt zweckmäßig auf einer Rüttelapparatur bei Raumtemperatur. Anschließend wird die Lösung durch einen 0.2 μm Filter in ein gereinigtes, partikelfreies Probenglas druckfiltriert. Die Viskosität der Polymerlösung kann durch Variation der gelösten Masse an Polymer verändert werden.

Beispiel 13: Verbesserung der Haftung durch Haftvermittlerlösungen

Durch Verwendung von Haftvermittlern kann die Haftung der Polymere auf in der Mikroelektronik relevanten Oberflächen wie z. B. Silizium, Siliziumoxid, Siliziumnitrid, Tantalnitrid, Glas oder Quarz verbessert werden.
Als Haftvermittler können z. B. folgende Verbindungen verwendet werden:

HV1

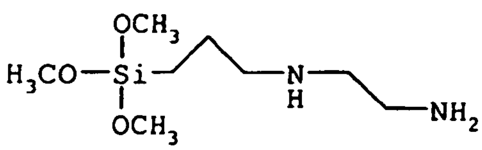

HV2

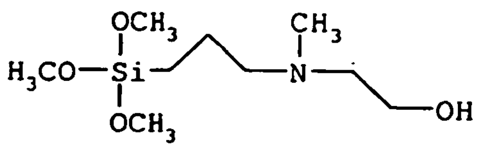

HV3

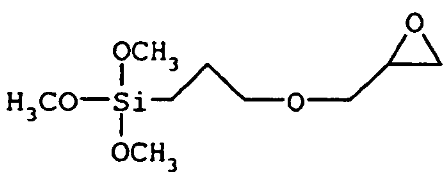

HV4

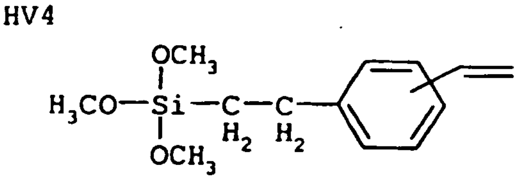

HV5

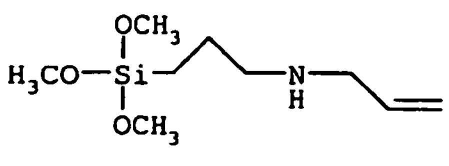

HV6

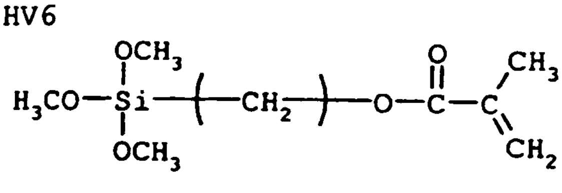

0,5 g Haftvermittler (z.B. N-(2-Aminoethyl)-3-aminopropylmethyldimethoxysilan) werden in ein gereinigtes, partikelfreies Probenglas bei Raumtemperatur in 95g Methanol, Ethanol oder Isopropanol (VLSI-Selectipur®) und 5g VE Wasser gelöst. Nach 24 h Stehen bei Raumtemperatur ist die Haftvermittlerlösung einsatzbereit. Diese Lösung ist maximal 3 Wochen verwendbar.

Der Haftvermittler soll eine monomolekulare Schicht auf der Oberfläche der zu klebenden Teile ergeben. Der Haftvermittler kann zweckmäßigerweise durch Schleudertechnik aufgetragen werden. Dazu wird die Haftvermittlerlösung über ein 0,2 µm Vorfilter auf die zu klebende Fläche aufgetragen und 30 s bei 5000 U/min geschleudert. Anschließend erfolgt ein Trocknungsschritt 60 s bei 100 °C.

Beispiel 14: Auftragen eines Polymers durch Schleuderverfahren und Zyklisierung zum Polybenzoxazol

Ein prozessierter Siliziumwafer, der Stege und Gräben bis zu einer Minimaldimension von jeweils ca. 150 nm hat, wird, wie im Beispiel 10 beschrieben, mit dem Haftvermittler beschichtet. Danach wird die filtrierte Lösung des Polymers, das entsprechend Beispiel 1 synthetisiert wurde, mittels einer Spritze auf den Wafer aufgetragen und mit einer Schleuder gleichmäßig verteilt. Die Schleuderumdrehungszahl beträgt dabei 2000 u/min. Anschließend wird das Polymer auf einer Heizplatte für 1 min. bei 120 °C und für 2 min. auf 200 °C erhitzt. Danach wird der beschichtete Wafer in einem Ofen unter Stickstoff oder Argon für 60 min. auf 425 °C erhitzt. Das so erhaltene Polybenzoxazol ist inert gegen Säuren, Basen und organische Lösemittel.

Beispiel 15: Bestimmung der Haftung der Polymere auf einer Titannitrid-Schicht

Ein 4" Siliziumwafer wird mit einer 50 nm dicken Titannitrid-schicht besputtert. Auf diesen Wafer wird die oben genannte Lösung aufgeschleudert, 5 s bei 500 U/min und 25 s bei 2000 U/min. Nach einem kurzen Softbake von 1 min. bei 120 °C auf einer Heizplatte werden 10 Siliziumchips der Größe 4x4 $mm^2$, die ebenfalls auf der Oberfläche mit 50 nm Titannitrid besputtert wurden, auf den Polymer-Film mit einer Kraft von 2N angedrückt. Anschließend wird dieser Stapel 1h bei 425 °C in einem Ofen in einer Stickstoffatmosphäre getempert.

Nach Abkühlung auf Raumtemperatur wird ein Haftungstest mittels eines Schertesters, Dage Serie 400, durchgeführt. Der Mittelwert der Kraft für Polymer 1, der zum Abscheren der Chips benötigt wurde, liegt bei 18,07 $N/mm^2$.

Beispiel 16: Bestimmung der Haftung der Polymere auf einer Tantalnitrid-Schicht

Versuch genauso durchgeführt wie bei Beispiel 15, mit dem Unterschied, dass hier die Oberfläche des Wafers und der Chips nicht aus Titannitrid sondern aus Tantalnitrid bestand. Der Mittelwert der Kraft für Polymer 1, der zum Abscheren der Chips benötigt wurde, liegt bei 16,79 $N/mm^2$.

Beispiel 17: Bestimmung der Haftung der Polymere auf Silizium

Versuch genauso durchgeführt wie bei Beispiel 15, mit dem Unterschied, dass hier die Oberfläche des Wafers und der Chips nicht aus Titannitrid sondern aus Silizium bestand. Der Mittelwert der Kraft für Polymer 1, der zum Abscheren der Si-Chips benötigt wurde, liegt bei 18,85 $N/mm^2$.

Beispiel 18: Bestimmung der Haftung der Polymere auf einer Siliziumnitrid-Schicht

Versuch genauso durchgeführt wie bei Beispiel 15, mit dem Unterschied, dass hier die Oberfläche des Wafers und der Chips nicht aus Titannitrid sondern aus Siliziumnitrid bestand. Der Mittelwert der Kraft für Polymer 1, der zum Abscheren der Chips benötigt wurde, liegt bei 17,15 $N/mm^2$.

Beispiel 19: Bestimmung der Haftung der Polymere auf einer Siliziumoxid-Schicht

Versuch genauso durchgeführt wie bei Beispiel 15, mit dem Unterschied, dass hier die Oberfläche des Wafers und der Chips nicht aus Titannitrid sondern aus Siliziumoxid bestand. Der Mittelwert der Kraft für Polymer 1, der zum Abscheren der Chips benötigt wurde, liegt bei 17,83 $N/mm^2$.

Beispiel 20: Bestimmung der Haftung der Polymere auf einer Siliziumcarbid-Schicht

Versuch genauso durchgeführt wie bei Beispiel 15, mit dem Unterschied, dass hier die Oberfläche des Wafers und der Chips nicht aus Titannitrid sondern aus Siliziumcarbid bestand. Der Mittelwert der Kraft für Polymer 1, der zum Abscheren der Chips benötigt wurde, liegt bei 17,94 $N/mm^2$.

Beispiel 21: Bestimmung der Haftung der Polymere auf einer Tantal-Schicht

Versuch genauso durchgeführt wie bei Beispiel 15, mit dem Unterschied, dass hier die Oberfläche des Wafers und der Chips nicht aus Titannitrid sondern aus Tantal bestand. Der Mittelwert der Kraft für Polymer 1, der zum Abscheren der Chips benötigt wurde, liegt bei 16,97 $N/mm^2$.

Beispiel 22: Bestimmung der Haftung der Polymere auf einer Titan-Schicht

Versuch genauso durchgeführt wie bei Beispiel 15, mit dem Unterschied, dass hier die Oberfläche des Wafers und der Chips nicht aus Titannitrid sondern aus Titan bestand. Der Mittelwert der Kraft für Polymer 1, der zum Abscheren der Chips benötigt wurde, liegt bei 17,52 $N/mm^2$.

Beispiel 23: Bestimmung der Haftung der Polymere auf einer Polyimid-Schicht

Versuch genauso durchgeführt wie bei Beispiel 15, mit dem Unterschied, dass hier die Oberfläche des Wafers und der Chips nicht aus Titannitrid sondern aus Polyimid bestand. Der Mittelwert der Kraft für Polymer 1, der zum Abscheren der Chips benötigt wurde, liegt bei 17,61 $N/mm^2$.

Beispiel 24: Vergleichsbeispiel Haftung

Ein Polymer, das analog Bsp. 1 von US 5,077,378 hergestellt wurde, wird wie in Bsp. 12 beschrieben in NMP gelöst. Mit dieser Lösung werden die Beispiele 15 bis 23 wiederholt. Es werden folgende Mittelwerte bestimmt:

| | |
|---|---|
| Oberfläche Titannitrid: | 14,71 $N/mm^2$ |
| Oberfläche Tantalnitrid: | 15,69 $N/mm^2$ |
| Oberfläche Silizium: | 15,21 $N/mm^2$ |
| Oberfläche Siliziumnitrid | 14,03 $N/mm^2$ |
| Oberfläche Siliziumoxid | 14,94 $N/mm^2$ |
| Oberfläche Siliziumcarbid | 13,37 $N/mm^2$ |
| Oberfläche Tantal | 13,96 $N/mm^2$ |
| Oberfläche Titan | 14,07 $N/mm^2$ |
| Oberfläche Polyimid | 13,02 $N/mm^2$ |

Beispiel 25: Bestimmung der chemischen Stabilität gegen organische Lösungsmittel

Auf drei 4" Siliziumwafern wird das Polymer 1 aus 20%-iger Lösung (Lösungsmittel NMP) aufgeschleudert, 5 s bei 500 U/min und 25 s bei 2000 U/min. Nach einem kurzen Softbake von 1 min. bei 120 °C und 2 min. bei 200 °C auf einer Heizplatte werden die Wafer 1 h bei 400 °C in einem Ofen in einer Stickstoffatmosphäre getempert. Nach Abkühlung auf Raumtemperatur wird je ein beschichteter Wafer 5 h in NMP, in Aceton und in Toluol auf 50 °C erhitzt. Anschließend werden die Wafer 60 min bei 200 °C im Vakuum getrocknet und die Massedifferenz bestimmt. Es werden keine Ablöseerscheinungen beobachtet.

| | | |
|---|---|---|
| Masseabnahme: | NMP | 1,1 % |
| | Aceton | 0,6 % |
| | Toluol . | 0,8 % |

Beispiel 26: Bestimmung der chemischen Stabilität gegen Säuren

Auf drei 4" Siliziumwafern wird das Polymer 2 aus 20 %-iger Lösung (Lösungsmittel NMP) aufgeschleudert, 5 s bei 500 U/min und 25 s bei 2000 U/min. Nach einem kurzen Softbake von 1 min. bei 120 °C und 2 min. bei 200 °C auf einer Heizplatte werden die Wafer 1 h bei 400 °C in einem Ofen in einer Stickstoffatmosphäre getempert. Nach Abkühlung auf Raumtemperatur wird je ein beschichteter Wafer 5 h in konz. HCl, in 50 %-ige Schwefelsäure und in Essigsäure auf 40 °C erhitzt. Anschließend werden die Wafer 60 min bei 200 °C im Vakuum getrocknet und die Massedifferenz bestimmt. Es werden keine Ablöseerscheinungen beobachtet.

| | | |
|---|---|---|
| Masseabnahme: | konz. HCl | 0,4 % |
| | 50 %-ige $H_2SO_4$ | 0,5 % |
| | Essigsäure | 0,1 % |

Beispiel 27: Bestimmung der chemischen Stabilität gegen Basen

Auf drei 4" Siliziumwafern wird das Polymer 3 aus 20 %-iger Lösung (Lösungsmittel NMP) aufgeschleudert, 5 s bei 500 U/min und 25 s bei 2000 U/min. Nach einem kurzen Softbake von 1 min. bei 120 °C und 2 min. bei 200 °C auf einer Heizplatte werden die Wafer 1h bei 400 °C in einem Ofen in einer Stickstoffatmosphäre getempert. Nach Abkühlung auf Raumtemperatur wird je ein beschichteter Wafer 5 h in 50 %-iger NaOH, in 47 %-iger KOH und in konz. Ammoniak auf 40 °C erhitzt. Anschließend werden die Wafer 60 min bei 200 °C im Vakuum getrocknet und die Massedifferenz bestimmt. Es werden keine Ablöseerscheinungen beobachtet.

| | | |
|---|---|---|
| Masseabnahme: | 50 %-ige NaOH | 0,9% |
| | 47 %-ige KOH | 1,0% |
| | konz. Ammoniak | 0,2% |

Beispiel 28: Bestimmung der Dielektrizitätskonstante von Polymer 1

Der für die Bestimmung der Dielektrizitätskonstante verwendete Versuchsaufbau ist in Fig. 1 dargestellt. Das Polymer 1 wird in NMP gelöst (25 %-ige Lösung) und die-Lösung über eine Membran mit 0,2 μm Poren druckfiltriert. Diese Lösung wird auf ein Substrat 1, auf dem sich bereits eine 600 nm dicke Ti-Schicht 2 befindet, aufgeschleudert. Die Schicht 3 wird bei 120 °C und 200 °C je 2 min. auf einer Heizplatte getrocknet und anschließend bei 430 °C, eine Stunde in einer Stickstoffatmosphäre getempert. Auf diese Schicht 3 werden anschließend über eine in Fig. 2 dargestellte Schattenmaske Titan-Elektroden 4 gesputtert. Die in Fig. 2 dargestellte Schattenmaske umfasst dazu Öffnungen 5, die in ihren Abmessungen und in ihrer Anordnung den Titan-Elektroden 4 entsprechen. Die Dielektrizitätskonstante wird mit dem Impedanzspektrometer 6 ermittelt und wird in einem Frequenzbereich von 100 Hz bis 1 MHz zu 2,41 bestimmt.

Beispiel 29: Bestimmung der Dielektrizitätskonstante von Polymer 2

Die Bestimmung der Dielektrizitätskonstante von Polymer 2 erfolgt analog Beispiel 28 und ergibt einen Wert von 2,55.

Beispiel 30: Bestimmung der Dielektrizitätskonstante von Polymer 3

Die Bestimmung der Dielektrizitätskonstante von Polymer 3 erfolgt analog Beispiel 28 und ergibt einen Wert von 2,38.

Beispiel 31: Bestimmung der Dielektrizitätskonstante von Polymer 4

Die Bestimmung der Dielektrizitätskonstante von Polymer 4 erfolgt analog Beispiel 28 und ergibt einen Wert von 2,6.

Beispiel 32: Bestimmung der Dielektrizitätskonstante von Polymer 8

Die Bestimmung der Dielektrizitätskonstante von Polymer 10 erfolgt analog Beispiel 28 und ergibt einen Wert von 2,41.

Beispiel 33: Vergleichsbeispiel Dielektrizitätskonstante

Ein nach Beispiel 28 durchgeführter Versuch mit einem Polymer, das analog Bsp. 1 von US 5,077,378 hergestellt wurde, ergibt im Frequenzbereich von 100 Hz bis 1 MHz eine Dielektrizitätskonstante von 3,1.

Beispiel 34: Bestimmung der Wasseraufnahme

Auf ein 4" Siliziumwafer mit bekannter Masse wird das Polymer 1 aus 20 %-iger Lösung (Lösungsmittel NMP)

aufgeschleudert, 5 s bei 500 U/min und 25 s bei 3500 U/min. Nach einem kurzen Softbake von 1 min. bei 120 °C auf einer Heizplatte wird der Wafer 1h bei 400 °C in einem Ofen in einer Stickstoffatmosphäre getempert. Mittels einer Analysenwaage AT261 Delta Range wird die Masse an Polymer 1 ermittelt.

Anschließend wird der beschichtete Wafer 10 h bei 80 °C in Wasser gelagert. Nach dem Abblasen des Wassers erfolgt eine weitere Gewichtsbestimmung. Aus der Massendifferenz wird die prozentuale Wasseraufnahme bezogen auf die Masse an Polybenzoxazol berechnet.

Ermittelte Wasseraufnahme: 0,75 %

Beispiel 35

Für dieses Beispiel wird ein Siliziumwafer verwendet, der zuerst mit einer Ti-W-Haftschicht (100 nm) und dann mit Kupfer (500 nm) durch Sputtern beschichtet wurde.

Die entsprechend Beispiel 12 hergestellte und filtrierte Lösung des Polymers 1, das entsprechend Beispiel 1 synthetisiert wurde, wird mittels einer Spritze auf einen Wafer (Cu-Oberfläche) aufgetragen und mit einer Schleuder gleichmäßig verteilt. Anschließend wird das Polymer auf einer Heizplatte für 1 min. bei 120 °C und für 2 min. auf 200 °C erhitzt. Danach wird der beschichtete Wafer in einem Ofen unter Stickstoff oder Argon für 60 min. auf 425 °C erhitzt. Die Oberfläche des auf diese Weise erhaltenen Polybenzoxazol-Films zeigt sich bei mikroskopischer Untersuchung als glatt und sauber. Auf der Oberfläche sind keine Kupfer-Partikel oder Cluster zu erkennen.

Der Versuch wird mit den Polymeren 2 bis 10 wiederholt. Das Ergebnis bleibt gleich. Bei keinem Polymer ist eine Kupferdiffusion festzustellen.

Beispiel 36 (Vergleichsbeispiel)

Der Versuch aus Beispiel 35 wird genauso wiederholt, mit dem Unterschied, dass diesmal ein Polymer aus EP 0264678 (Beispiel 1) verwendet wird. Nach dem Tempern sieht man auf der Oberfläche des entstandenen Polybenzoxazol-Films das durchdiffundierte Kupfer.

**Patentansprüche**

1. Poly-o-hydroxyamide der Formel I

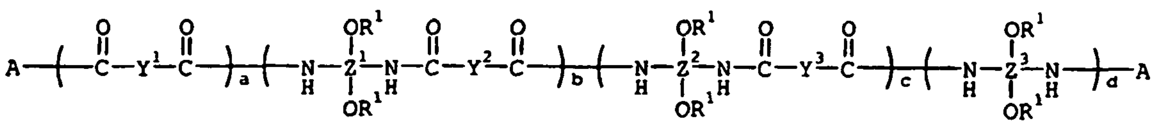

FORMEL I

wobei bedeutet:

$Y^2$ :

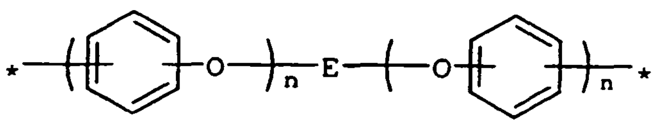

$Y^1$, $Y^3$: jeweils unabhängig, die gleiche Bedeutung wie $Y^2$, sowie

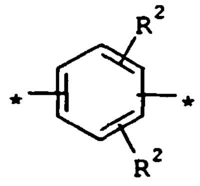
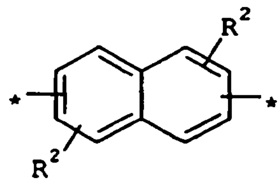
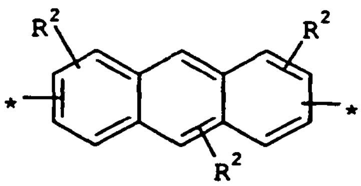

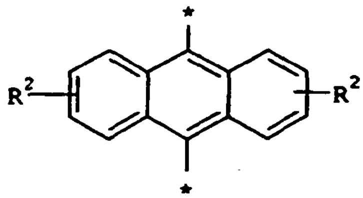
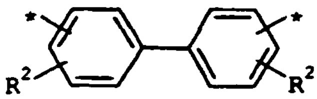
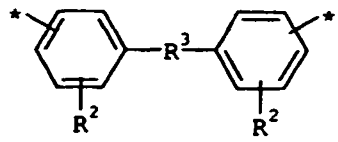

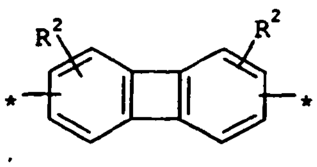
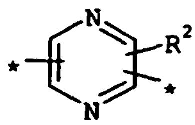
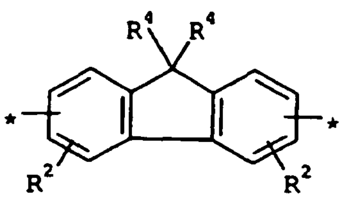

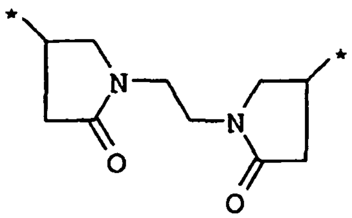
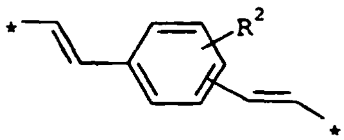
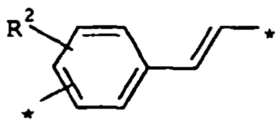

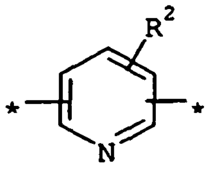
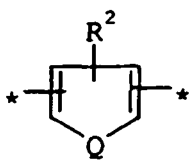
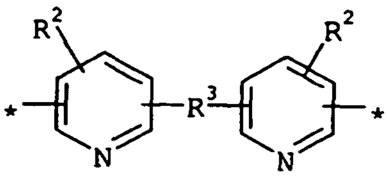
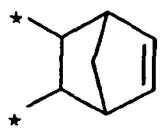

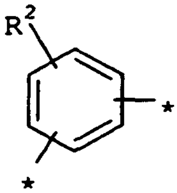
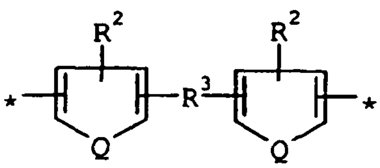
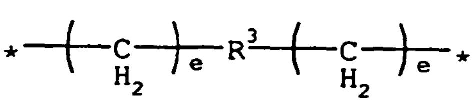

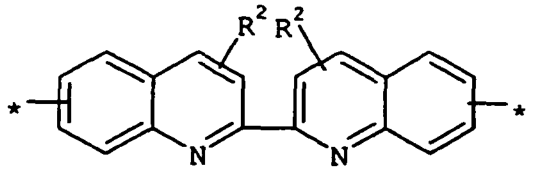

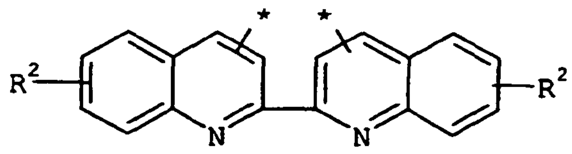

$Z^1$, $Z^2$, $Z^3$, jeweils unabhängig:

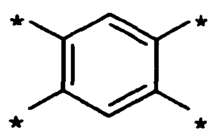

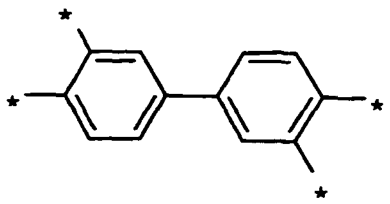

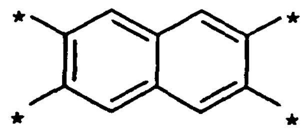

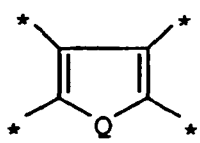

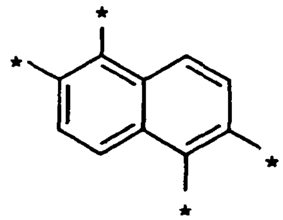

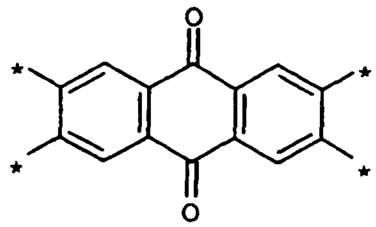

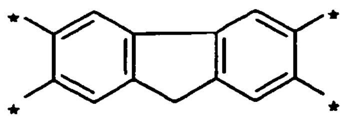

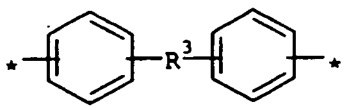

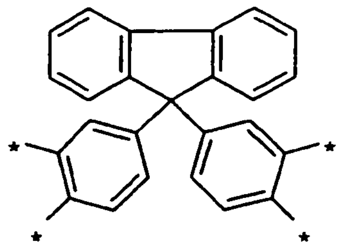

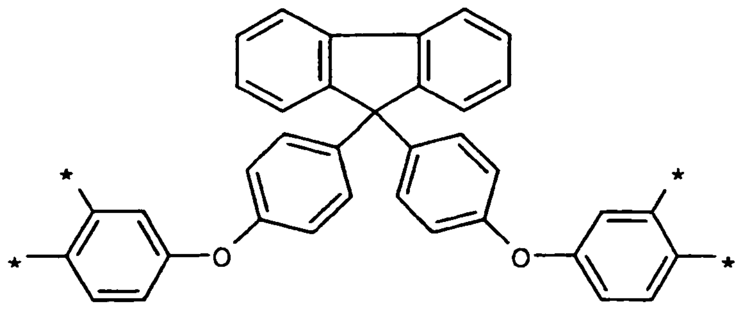

;

A: wenn a = 0 und/oder d = 1

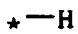 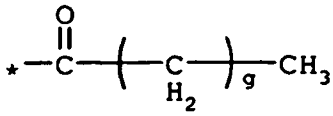 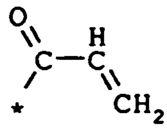 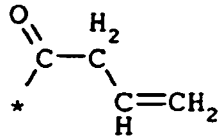

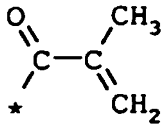 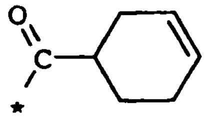 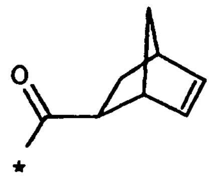 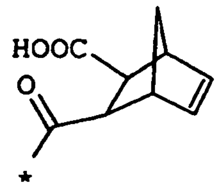

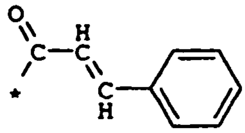 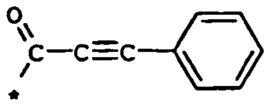 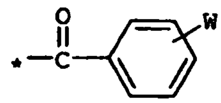 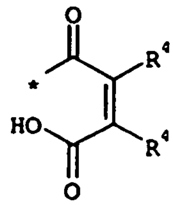

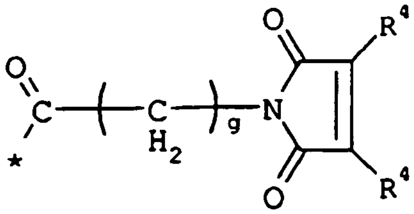 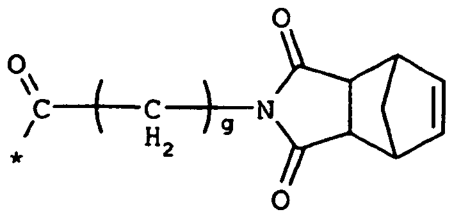 ;

wenn a = 1 und/oder d = 0

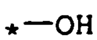 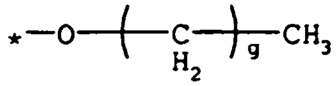 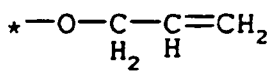

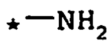 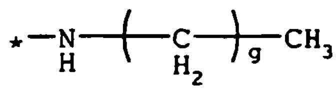 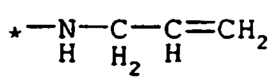

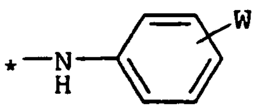
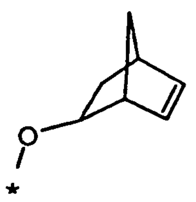
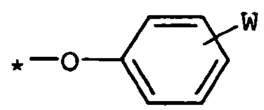

;

E:

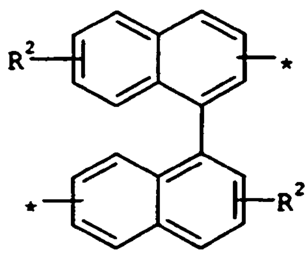
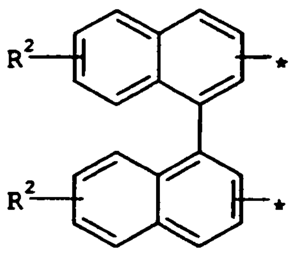
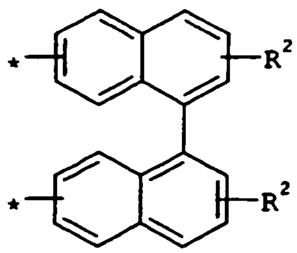

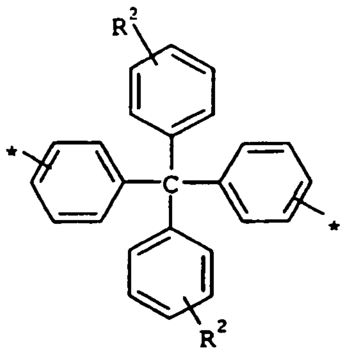
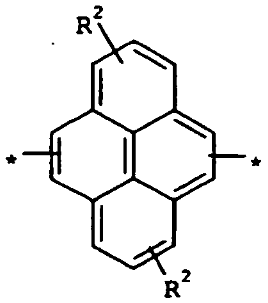
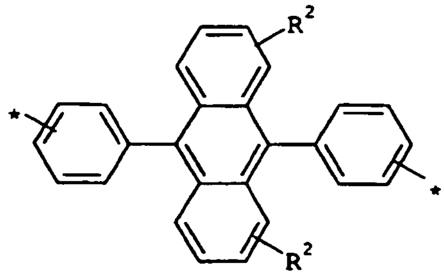

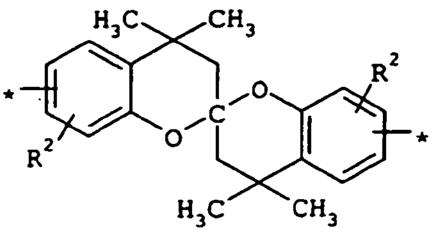
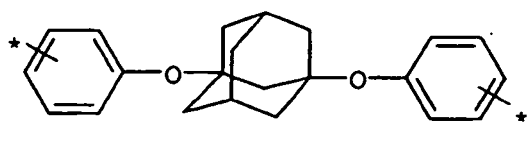

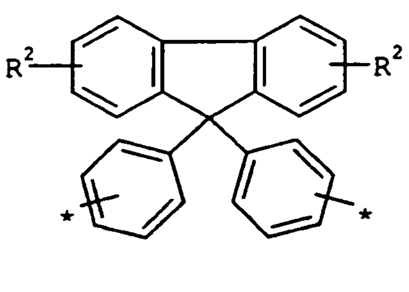
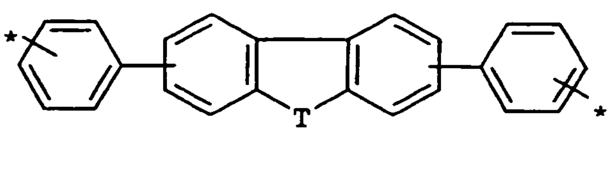

;

W:

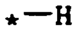 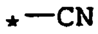 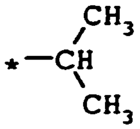 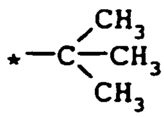 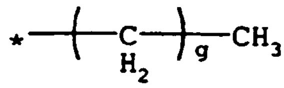

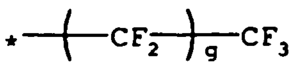 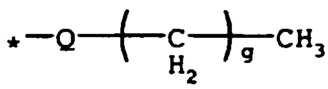 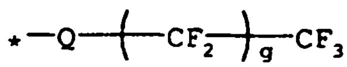

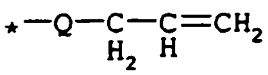 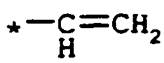 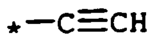 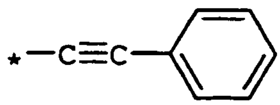

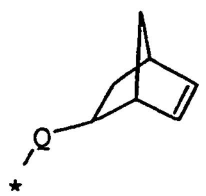 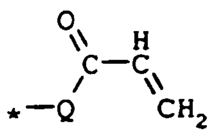 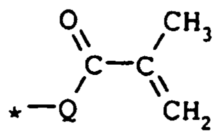 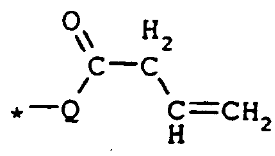

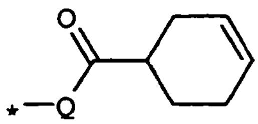 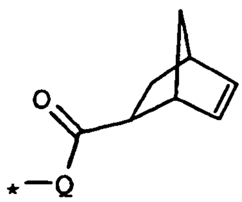 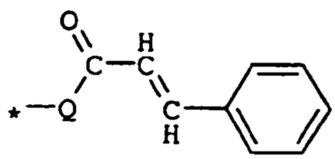

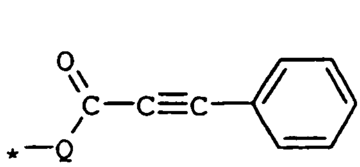 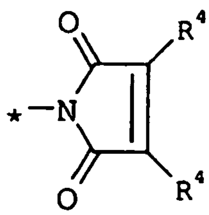 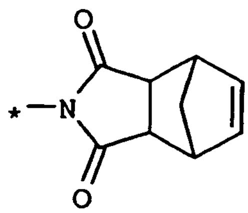

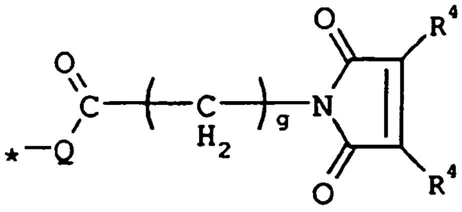

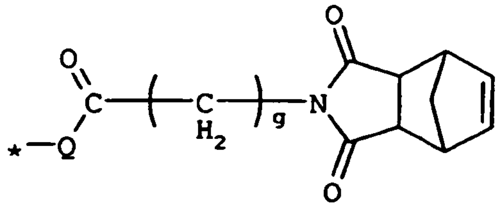

;

T:

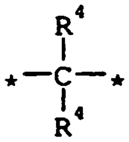

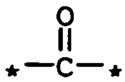

$*-O-*$

$*-S-*$

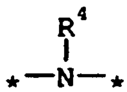

;

Q:

$*-O-*$

$*-S-*$

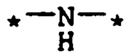

;

$R^1$:

$*-H$

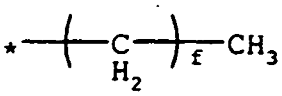

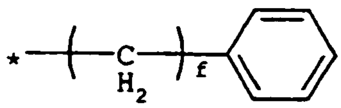

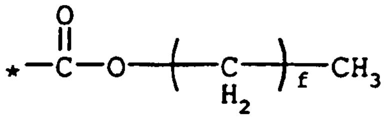

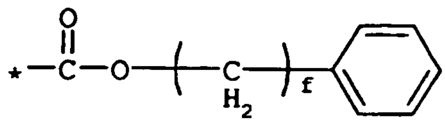

;

$R^2$: -H, $-CF_3$, -OH, -SH, -COOH, $-N(R^5)_2$, eine Alkylgruppe, eine Arylgruppe, eine Heteroarylgruppe, sowie

$*-C\equiv CH$

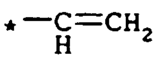

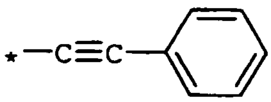

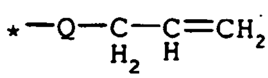

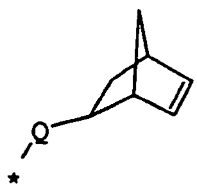 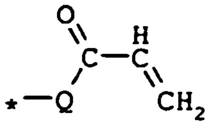 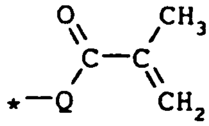 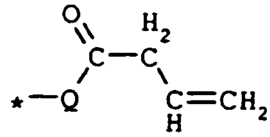

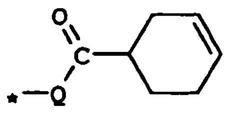 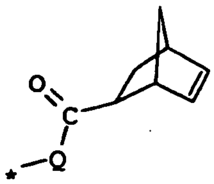 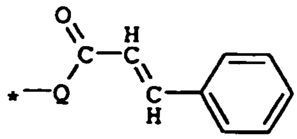 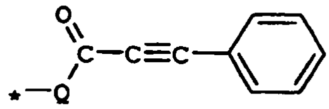

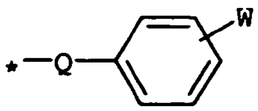 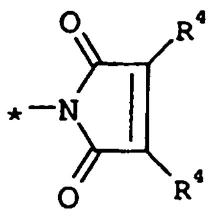 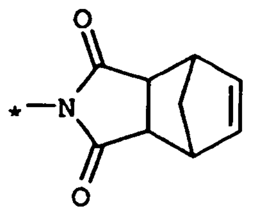

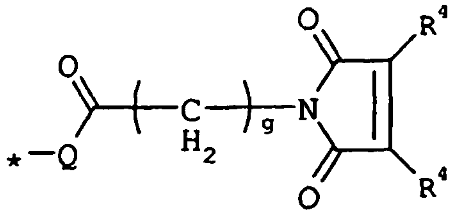 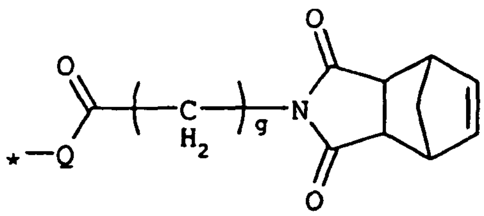 ;

$R^3$:

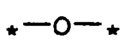 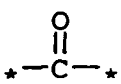 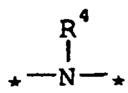 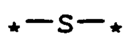 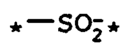 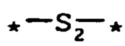 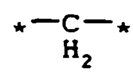

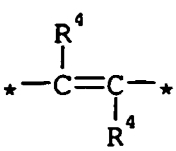 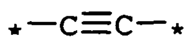 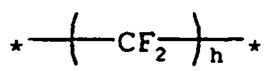 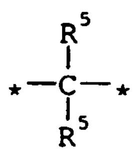

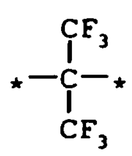 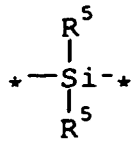 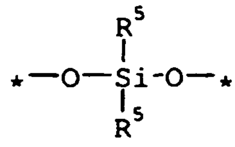 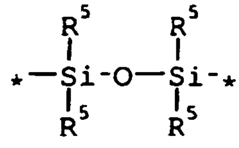

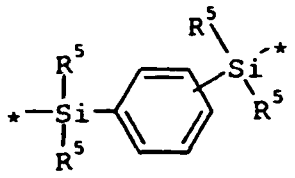 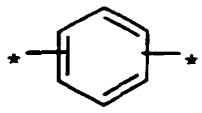 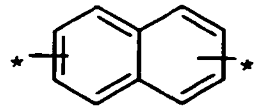 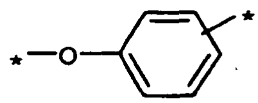

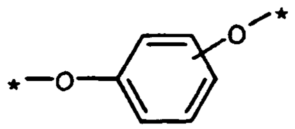 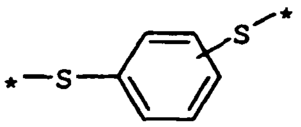 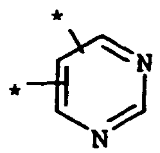 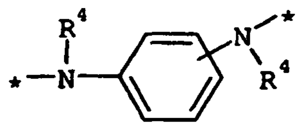

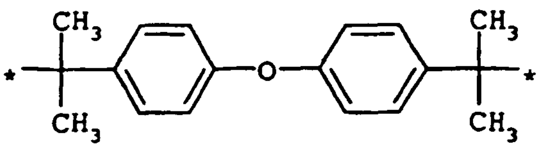 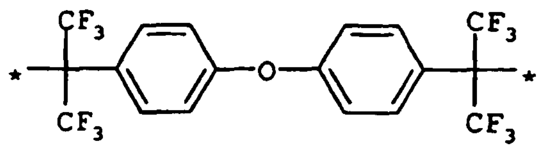

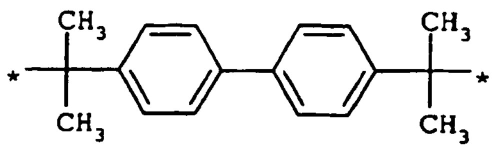 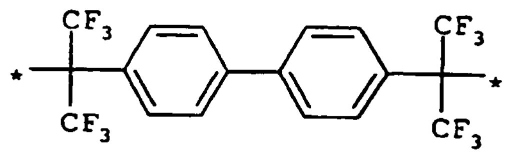 ;

R4:

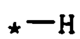 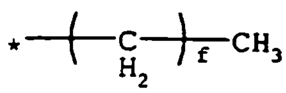 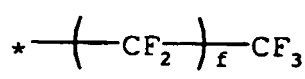

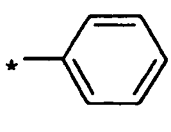 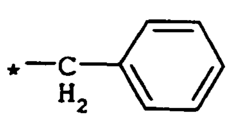 ;

R5: einen Alkyl-, einen Aryl- oder einen Heteroarylrest;

a: 0 oder 1;
b: 1 - 200;
c: 0 - 200;
d:0 oder 1;
e:0 - 10;
f: 0 - 10;
g: 0 - 10;
h: 1 - 10;
n: 0 oder 1;

wobei wenn $R^3 = -CH_2-$, ist x = 0 - 10
und das Substitutionsmuster der Gruppen $Z^1$, $Z^2$ und $Z^3$ so gewählt wird, dass jeweils ein aus einer -NH-Gruppe und einer $OR^1$-Gruppe gebildetes Paar in ortho-Stellung zu einander angeordnet sind.

**2.** Poly-o-hydroxyamide nach Anspruch 1, wobei zumindest eine der folgenden Bedingungen gilt:

$$b = 5 - 50;$$

$$c = 0 - 50.$$

**3.** Poly-o-hydroxyamide nach Anspruch 1 oder 2, wobei gilt:

$$n = 1.$$

**4.** Poly-o-hydroxyamide nach einem der vorhergehenden Ansprüche, wobei weitere Wiederholungseinheiten im Poly-o-hydroxyamid der Formel I vorgesehen sind, die thermisch labil sind und beim Erhitzen ein Gas freisetzen.

**5.** Poly-o-hydroxyamide nach Anspruch 4, wobei die thermisch labilen Wiederholungseinheiten als Block im Poly-o-hydroxyamid der Formel I angeordnet sind.

**6.** Polybenzoxazole, erhalten aus Poly-o-hydroxyamiden nach einem der Ansprüche 1 bis 5.

**7.** Verfahren zur Herstellung von Poly-o-hydroxyamiden der Formel I, wobei zumindest ein Monomer der Formel II

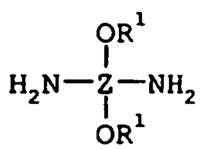

Formel II

wobei Z steht für $Z^1$, $Z^2$ oder $Z^3$, und $Z^1$, $Z^2$, $Z^3$ sowie $R^1$ die in Anspruch 1 angegebene Bedeutung aufweisen, mit zumindest einer Dicarbonsäure oder einem aktivierten Dicarbonsäurederivat der Formel III umgesetzt wird,

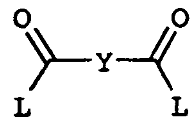

Formel III

wobei L für eine Hydroxygruppe oder eine aktivierende Gruppe steht und Y für $Y^1$, $Y^2$ oder $Y^3$ steht, und $Y^1$, $Y^2$, $Y^3$ die in Anspruch 1 angegebene Bedeutung aufweisen.

**8.** Verfahren nach Anspruch 7, wobei die Umsetzung in Gegenwart einer Base durchgeführt wird.

**9.** Verfahren zur Herstellung von Polybenzoxazolen nach Anspruch 6, wobei Poly-o-hydroxyamide der Formel I erhitzt werden.

**10.** Elektronisches Bauteil, umfassend ein Dielektrikum, welches ein Polybenzoxazol nach Anspruch 6 enthält.

**11.** Verfahren zur Herstellung eines elektronischen Bauteils nach Anspruch 10, wobei eine Lösung eines Poly-o-hydroxyamids der Formel I in einem Lösungsmittel hergestellt wird, die Lösung auf ein Substrat aufgebracht und das Lösungsmittel verdampft wird, so dass ein Film erhalten wird, der Film erhitzt wird, um das Poly-o-hydroxyamid der Formel I zum Polybenzoxazol nach Anspruch 6 zu cyclisieren und der Film strukturiert wird, um eine Resiststruktur zu erhalten, welche Gräben und Kontaktlöcher aufweist, auf der Resiststruktur ein leitendes Material abgeschieden wird, so dass die Gräben und Kontaktlöcher mit dem leitenden Material ausgefüllt sind, und überschüssiges leitendes Material entfernt wird.

**12.** Verfahren zur Herstellung eines elektronischen Bauteils nach Anspruch 10, wobei eine Lösung eines Poly-o-hydroxyamids der Formel I in einem Lösungsmittel hergestellt wird, die Lösung auf ein Substrat aufgebracht wird, welches auf seiner Oberfläche metallische Strukturen aufweist, zwischen denen Gräben und Kontaktlöcher angeordnet sind, das Lösungsmittel verdampft wird, so dass die Gräben und Kontaktlöcher mit dem Poly-o-hydroxyamid der Formel I ausgefüllt sind, und das Substrat erhitzt wird, um das Poly-o-hydroxyamid der Formel I zum Polybenzoxazol nach Anspruch 6 zu cyclisieren.

**13.** Verfahren nach einem der Ansprüche 11 oder 12, wobei der Lösung des Poly-o-hydroxyamids der Formel I ein Porogen zugegeben ist.

**Claims**

**1.** Poly-o-hydroxyamides of the formula I

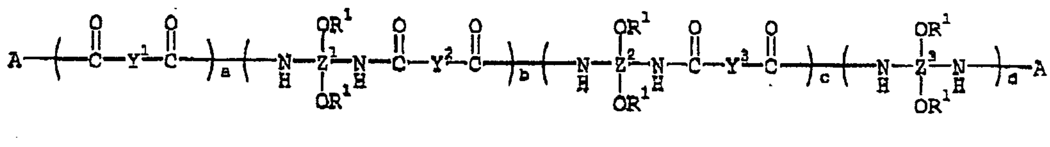

FORMULA I

in which:

$Y^2$ is

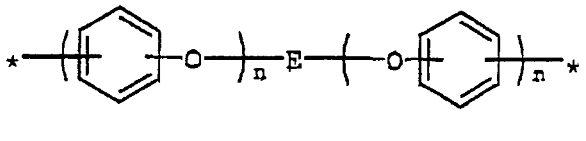

$Y^1$ and $Y^3$, in each case independently of one another, have the same meaning as $Y^2$, and are

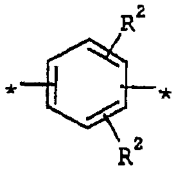

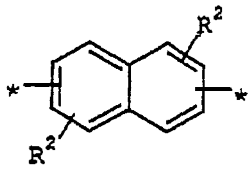

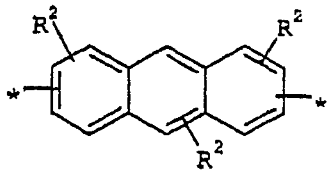

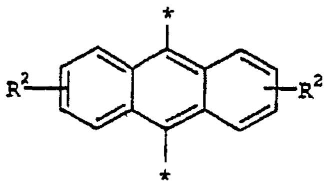

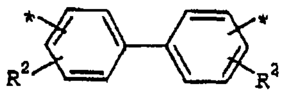

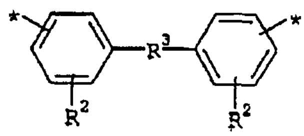

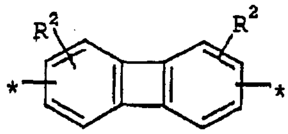

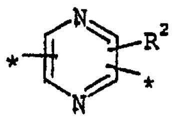

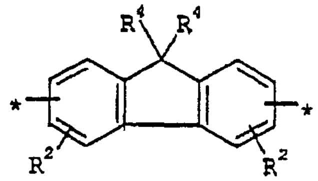

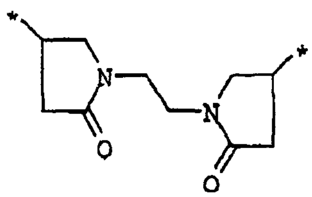

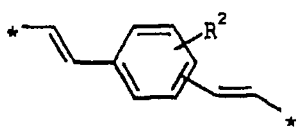

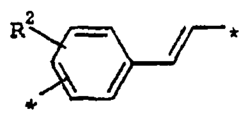

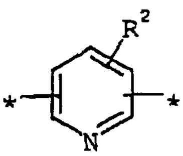

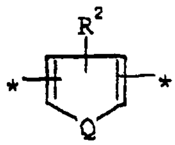

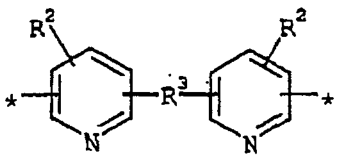

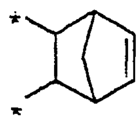

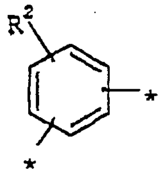
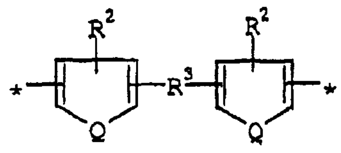
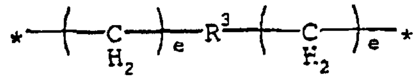

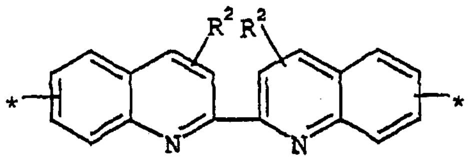
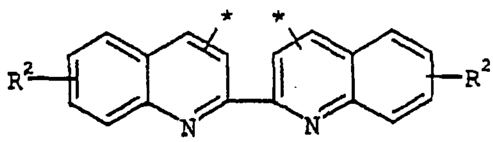

$Z^1$, $Z^2$ and $Z^3$, in each case independently, are

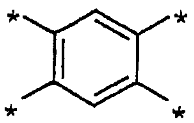
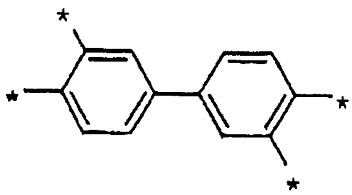
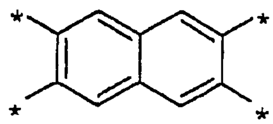

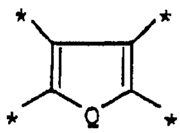
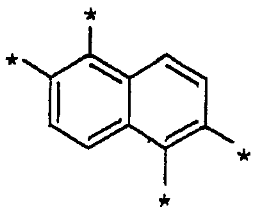
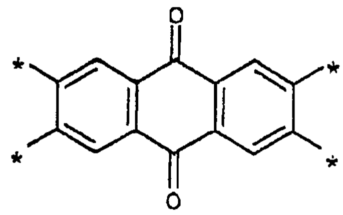

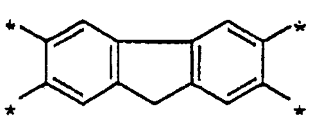
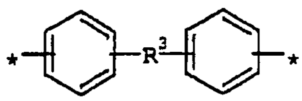
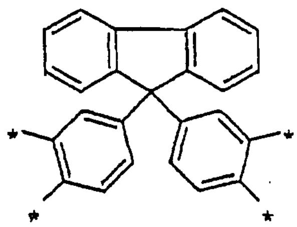

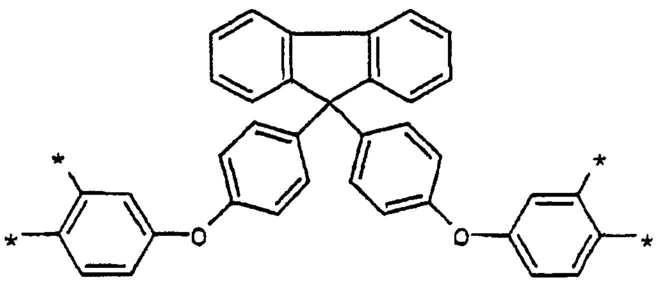

;

A, if a = 0 and/or d = 1, is

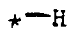

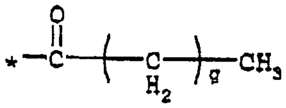

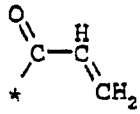

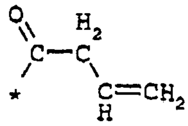

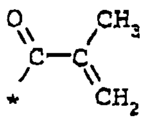

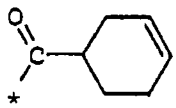

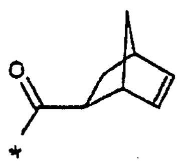

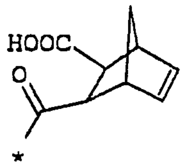

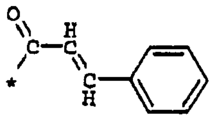

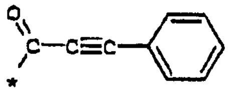

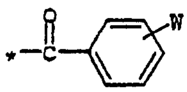

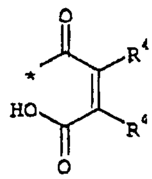

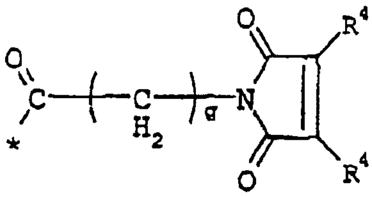

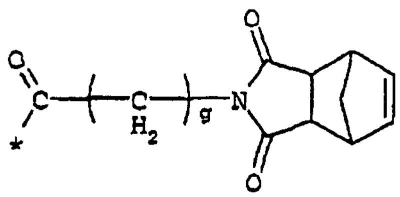

;

if a = 1 and/or d = 0, is

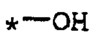

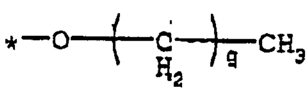

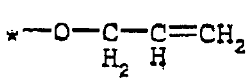

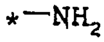

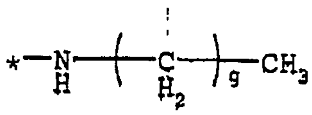

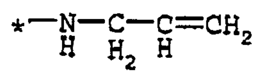

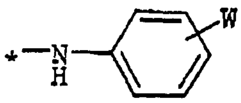

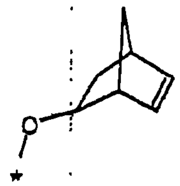

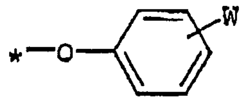

;

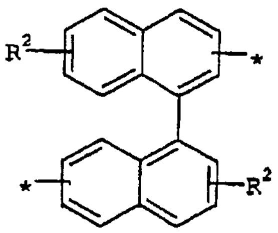

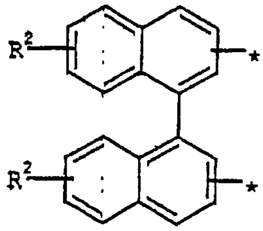

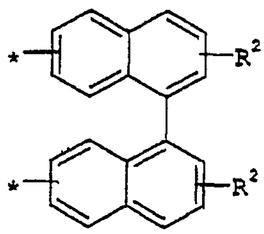

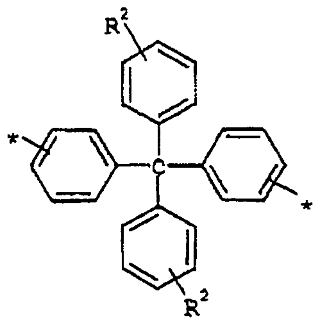

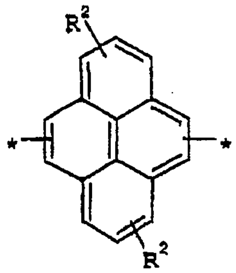

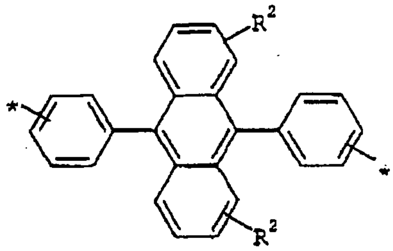

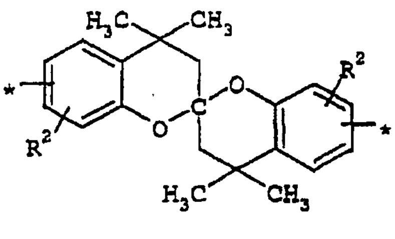

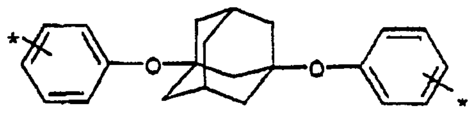

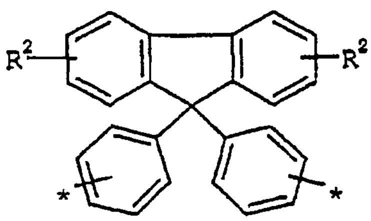 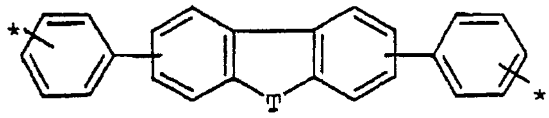

;

W is

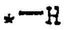 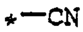 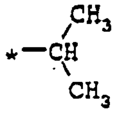 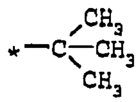 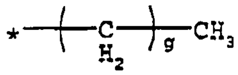

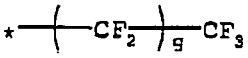 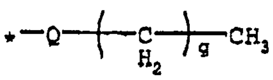 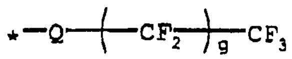

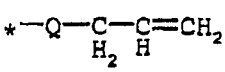 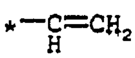 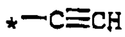 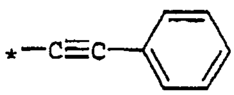

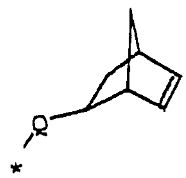 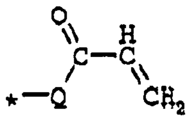 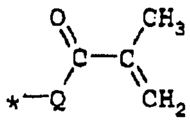 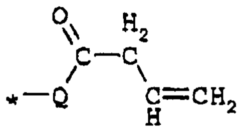

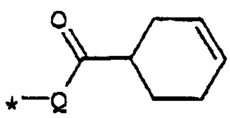 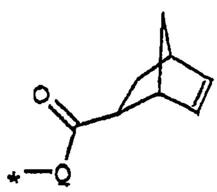 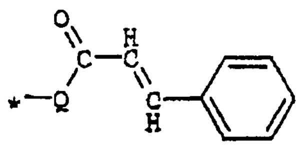

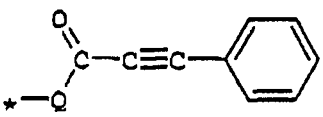 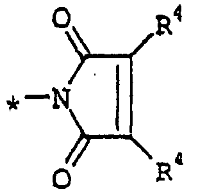 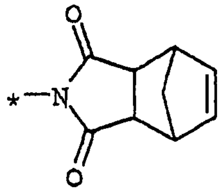

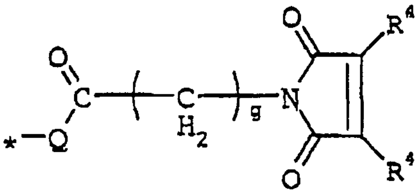 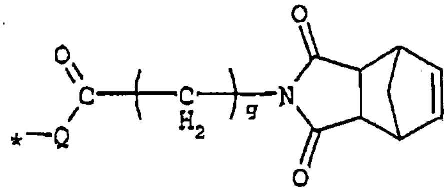 ;

T is

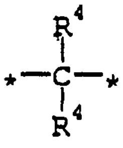 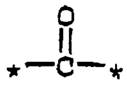 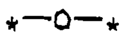 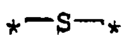 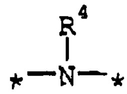 ;

Q is

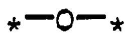 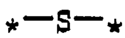 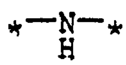 ;

$R^1$ is

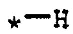 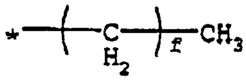 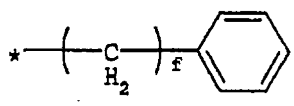

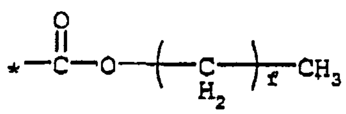 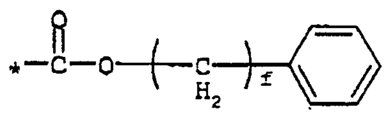 ;

$R^2$ is -H, $-CF_3$, -OH, -SH, -COOH, $-N(R^5)_2$, an alkyl group, an aryl group, a heteroaryl group and

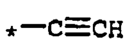 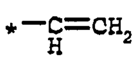 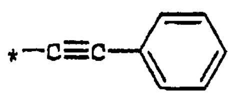 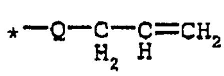

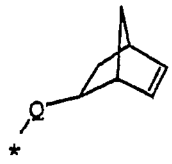 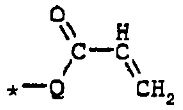 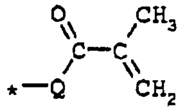 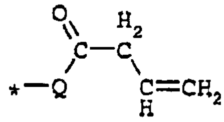

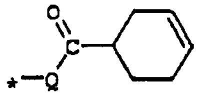 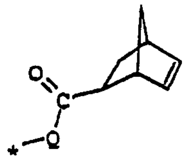 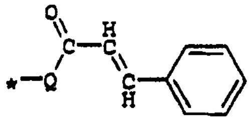 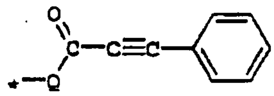

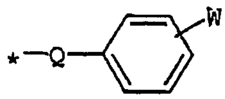 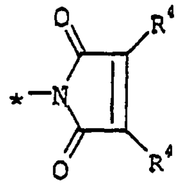 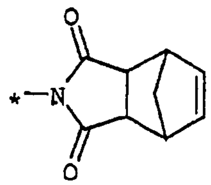

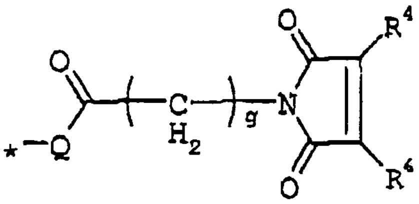 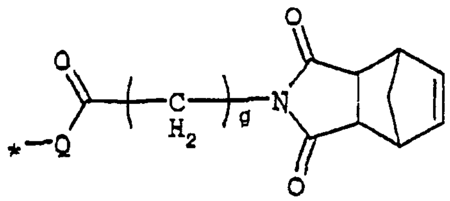 ;

$R^3$ is

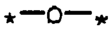 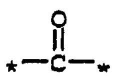 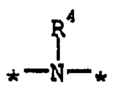 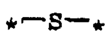 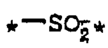 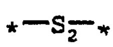 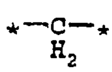

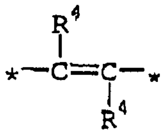 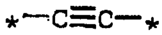 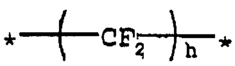 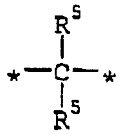

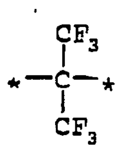 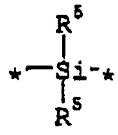 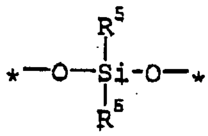 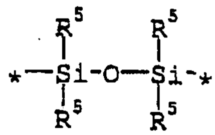

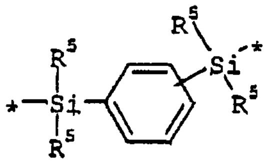 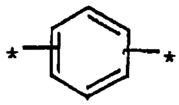 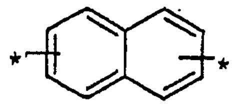 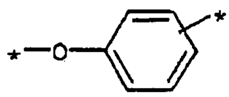

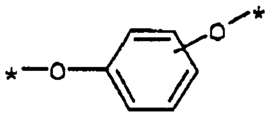 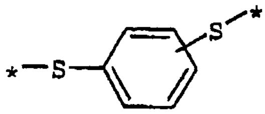 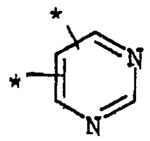 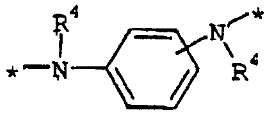

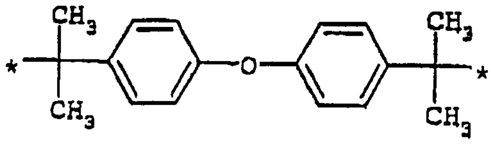 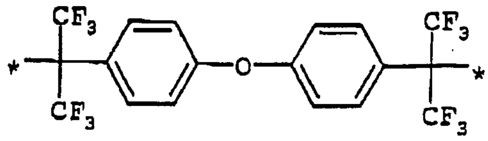

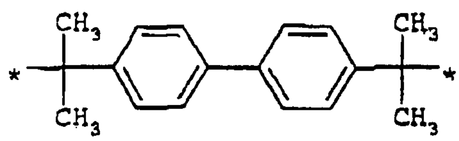 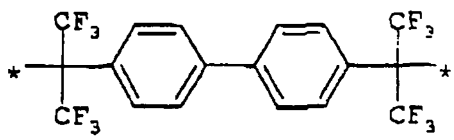 ;

$R^4$ is

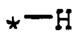 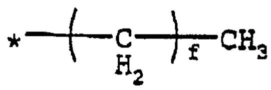 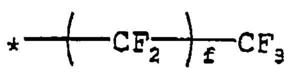

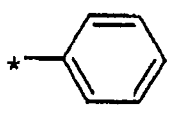 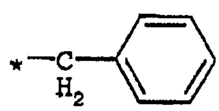 ;

$R^5$ is an alkyl, an aryl or a heteroaryl radical;

a is 0 or 1;
b is 1 - 200;
c is 0 - 200;

d is 0 or 1;
e is 0 - 10;
f is 0 - 10;
g is 0 - 10;
h is 1 - 10;
n is 0 or 1;

x being 0 - 10 if $R^3$ is $-CH_2-$ and the substitution pattern of the groups $Z^1$, $Z^2$ and $Z^3$ is chosen so that in each case a pair formed from an -NH group and an $OR^1$ group are arranged in the ortho position to one another.

**2.** Poly-o-hydroxyamides according to Claim 1, wherein at least one of the following conditions applies:

$$b = 5 - 50;$$

$$c = 0 - 50.$$

**3.** Poly-o-hydroxyamides according to Claim 1 or 2, wherein the following applies:

$$n = 1.$$

**4.** Poly-o-hydroxyamides according to any of the preceding claims, wherein further repeating units which are thermally labile and liberate a gas on heating are provided in the poly-o-hydroxyamide of the formula I.

**5.** Poly-o-hydroxyamides according to Claim 4, wherein the thermally labile repeating units are arranged as a block in the poly-o-hydroxyamide of the formula I.

**6.** Polybenzoxazoles obtained from a poly-o-hydroxyamide according to any of Claims 1 to 5.

**7.** Process for the preparation of poly-o-hydroxyamides of the formula I, wherein at least one monomer of the formula II

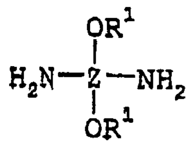

Formula II

in which Z is $Z^1$, $Z^2$ or $Z^3$, and $Z^1$, $Z^2$, $Z^3$ and $R^1$ have the meaning stated in claim 1,
is reacted with at least one dicarboxylic acid or one activated dicarboxylic acid derivative of the formula III

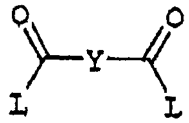

Formula III

in which L is a hydroxyl group or an activating group and Y is $Y^1$, $Y^2$ or $Y^3$, and $Y^1$, $Y^2$ and $Y^3$ have the meaning stated in claim 1.

**8.** Process according to Claim 7, wherein the reaction is carried out in the presence of a base.

**9.** Process for the preparation of polybenzoxazoles according to Claim 6, wherein poly-o-hydroxyamides of the formula I are heated.

**10.** Electronic component, comprising a dielectric which contains a polybenzoxazole according to Claim 6.

**11.** Process for the production of an electronic component according to Claim 10, wherein a solution of a poly-o-hydroxyamide of the formula I in a solvent is prepared, the solution is applied to a substrate and the solvent is evaporated so that a film is obtained, the film is heated in order to cyclize the poly-o-hydroxyamide of the formula I to give the polybenzoxazole according to Claim 6 and the film is structured in order to obtain a resist structure which has trenches and contact holes, a conductive material is deposited on the resist structure so that the trenches and contact holes are filled with the conductive material, and excess conductive material is removed.

**12.** Process for the production of an electronic component according to Claim 10, wherein a solution of a poly-o-hydroxyamide of the formula I in a solvent is prepared, the solution is applied to a substrate which has, on its surface, metallic structures between which trenches and contact holes are arranged, the solvent is evaporated so that the trenches and contact holes are filled with the poly-o-hydroxyamide of the formula I, and the substrate is heated in order to cyclize the poly-o-hydroxyamide of the formula I to the polybenzoxazole according to Claim 6.

**13.** Process according to either of Claims 11 and 12, wherein a porogen is added to the solution of the poly-o-hydroxyamide of the formula I.

**Revendications**

**1.** Poly-O-hydroxyamides de Formule I

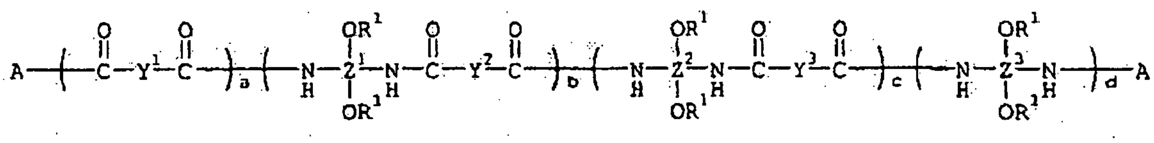

Formule I

avec les significations suivantes :

$Y^2$ :

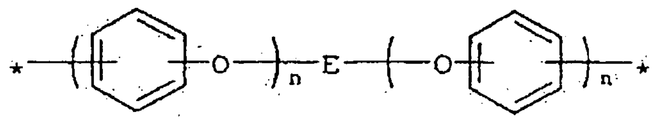

$Y^1$, $Y^3$ : ont, respectivement, indépendamment la même signification que $Y^2$, ainsi que

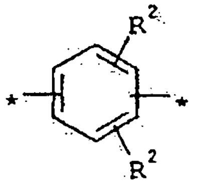
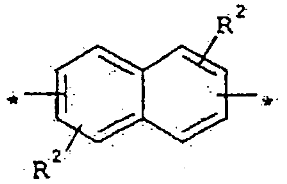
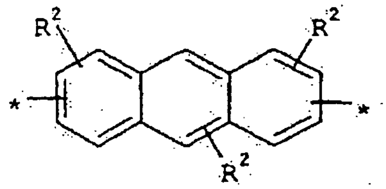

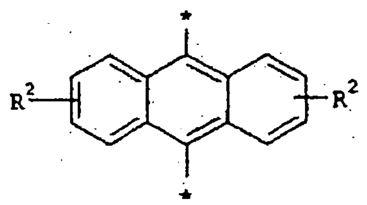
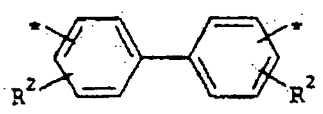
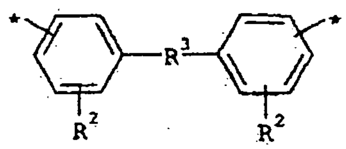

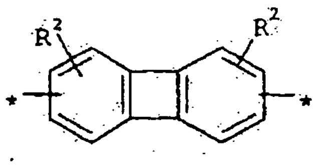
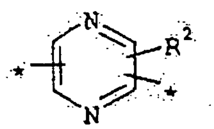
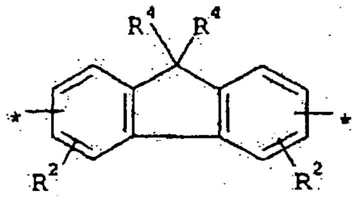

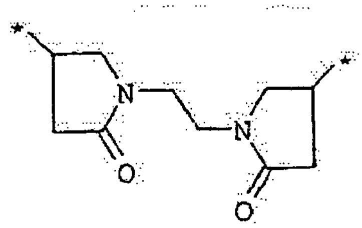
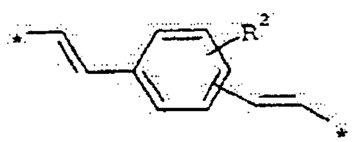
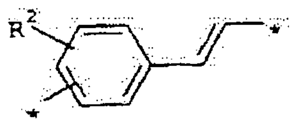

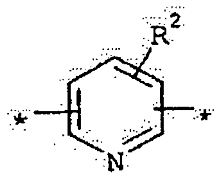
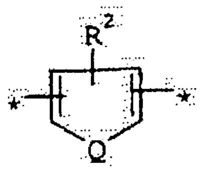
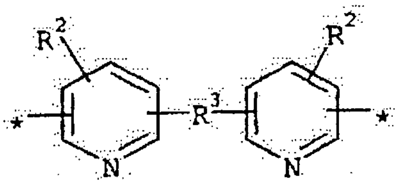
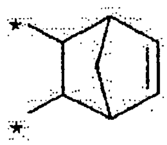

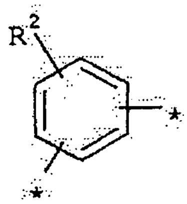
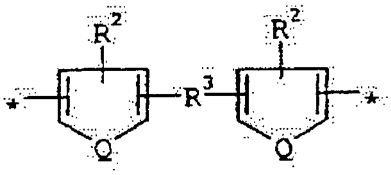
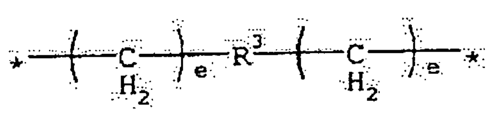

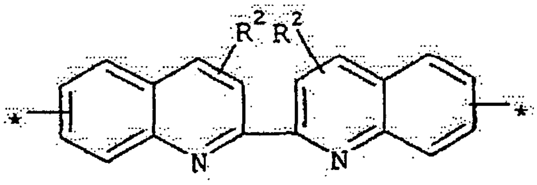
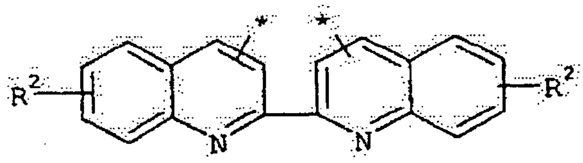

$Z^1$, $Z^2$, $Z^3$ sont, respectivement, indépendamment :

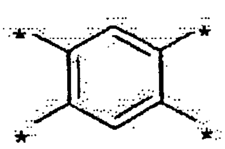
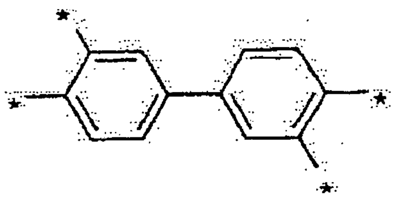
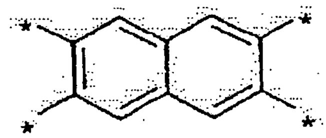

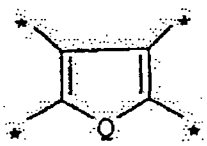
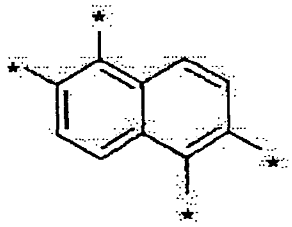
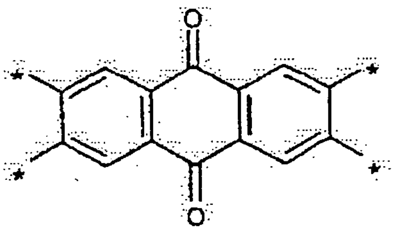

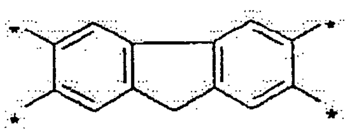
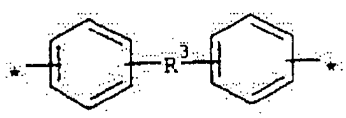
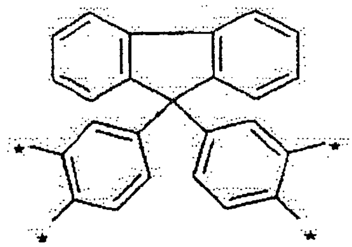

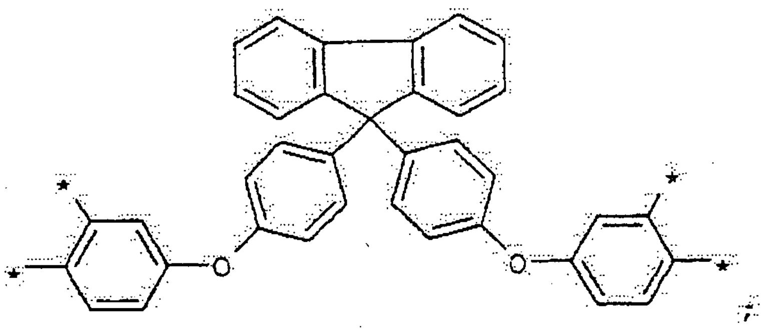
;

A : quand a = 0 et/ou d = 1

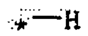

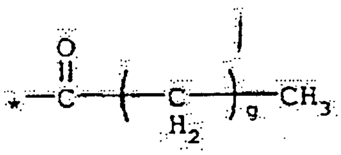

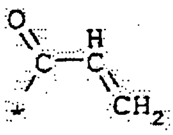

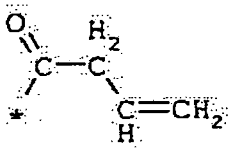

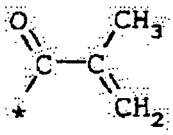

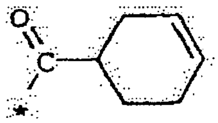

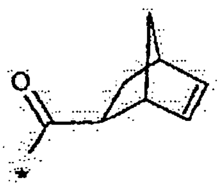

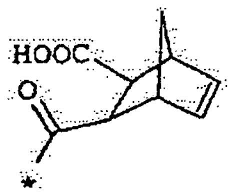

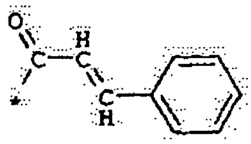

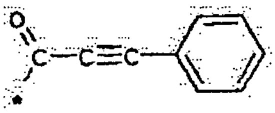

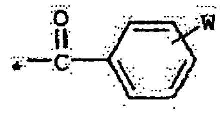

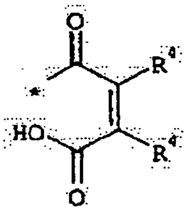

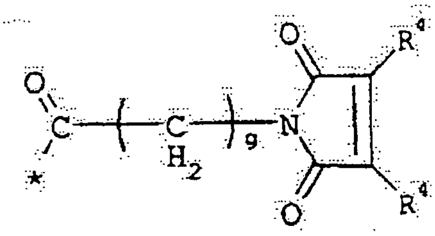

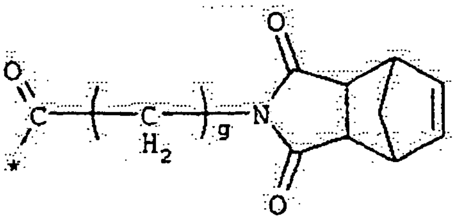
;

quand a = 1 et/ou d = 0

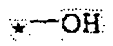
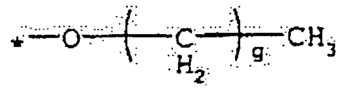
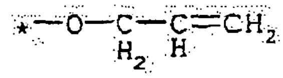

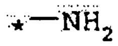
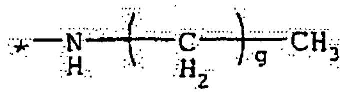
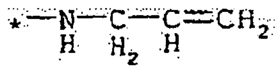

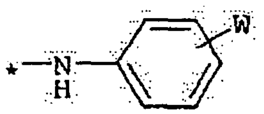
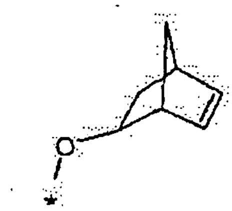
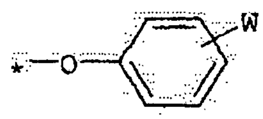

;

E:

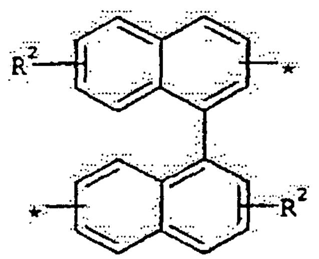
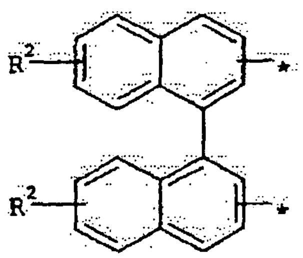
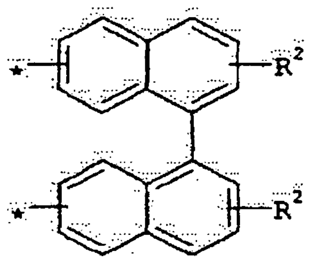

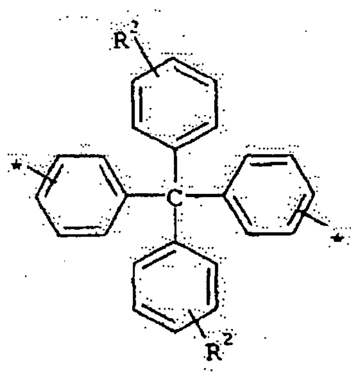
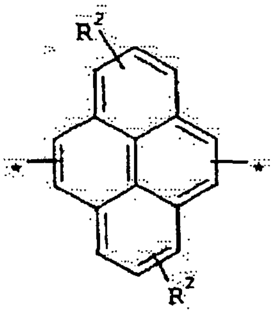
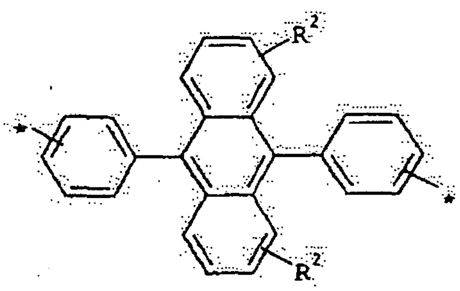

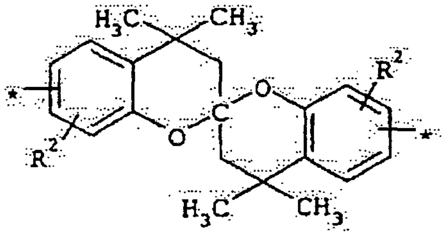

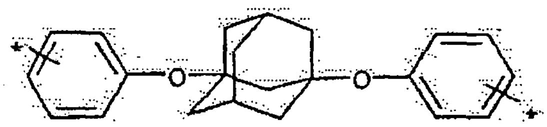

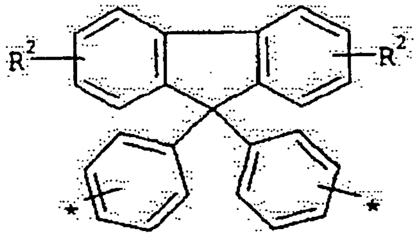

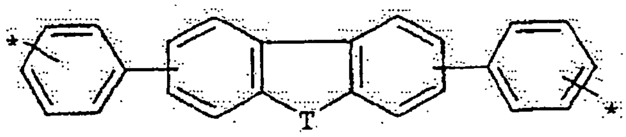

W :

$*-H$

$*-CN$

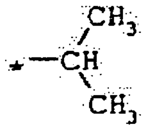

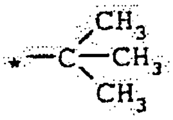

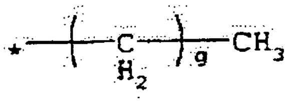

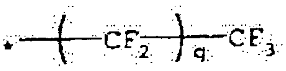

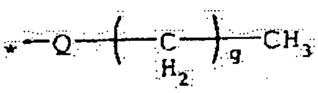

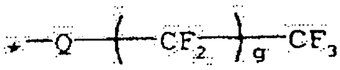

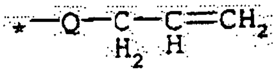

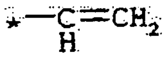

$*-C\equiv CH$

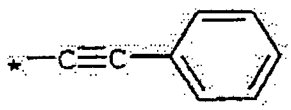

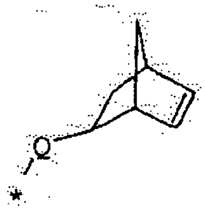

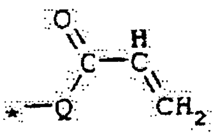

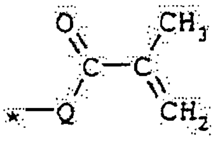

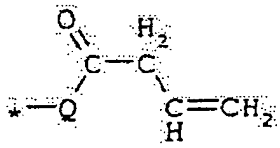

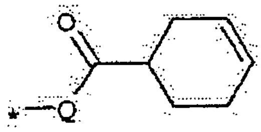
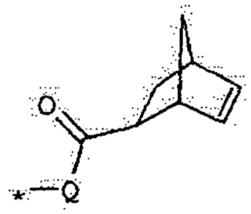
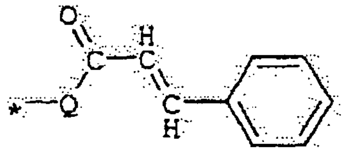

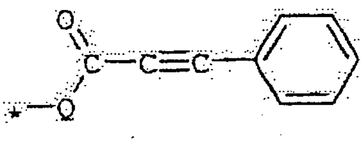
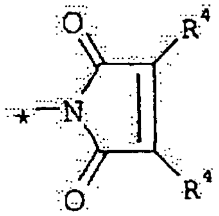
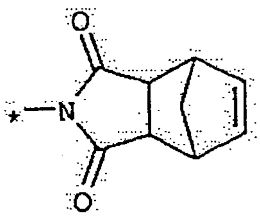

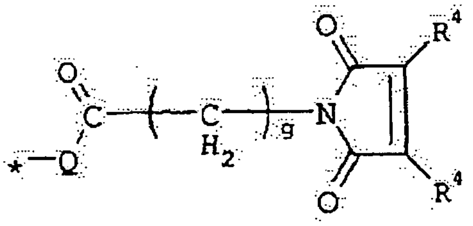
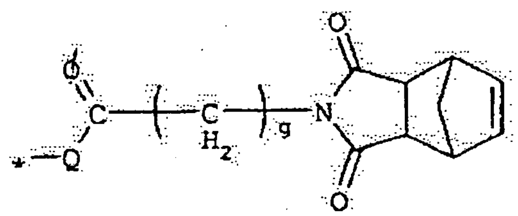
;

T :

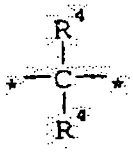
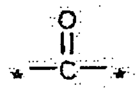
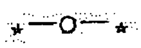
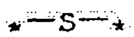
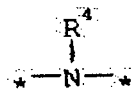
;

Q :

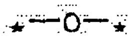
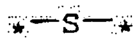
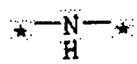
;

$R^1$

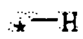
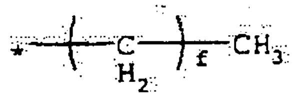
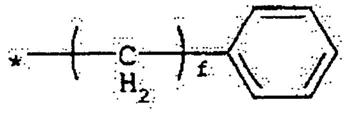

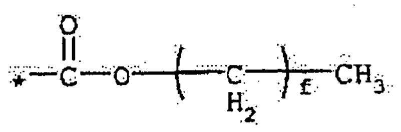
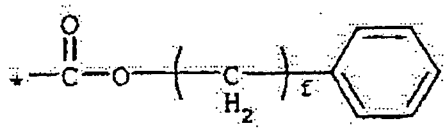
;

$R^2$ : -H, -$CF_3$, -OH, -SH, -COOH, -N $(R^5)_2$, un groupe alcoyle, un groupe aryle, un groupe hétéroaryle, ainsi que

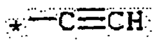
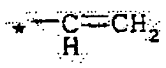
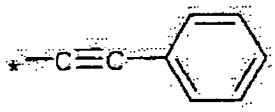
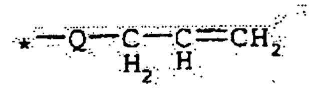

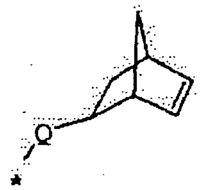
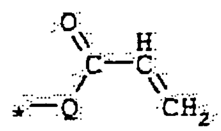
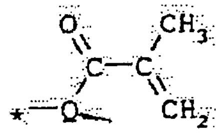
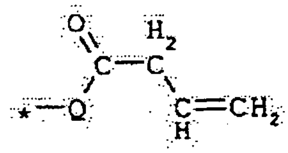

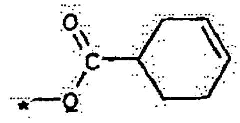
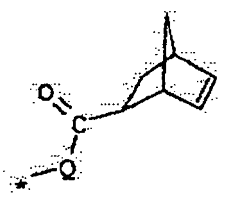
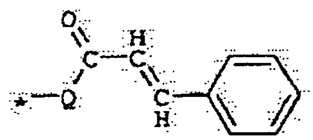
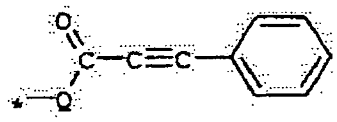

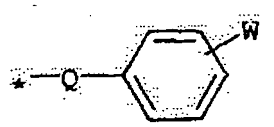
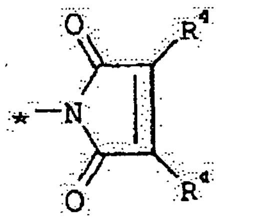
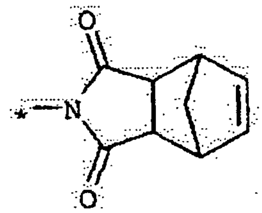

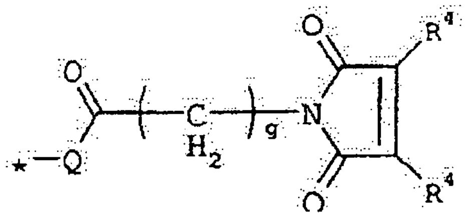

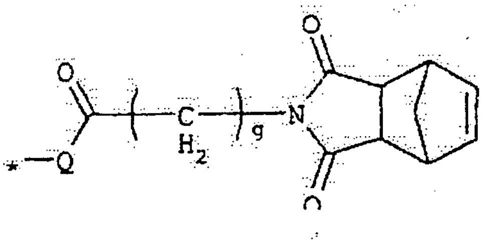

$R^3$ :

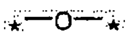

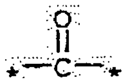

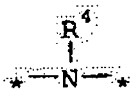

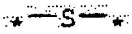

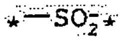

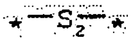

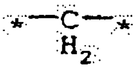

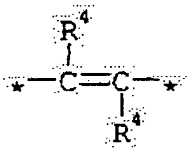

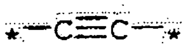

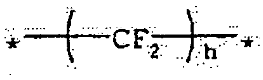

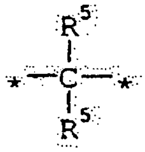

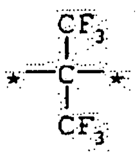

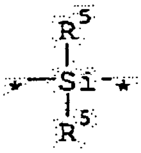

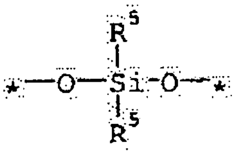

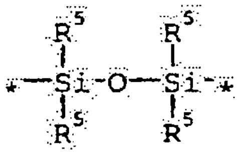

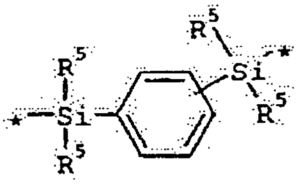

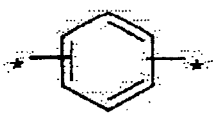

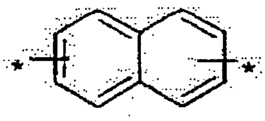

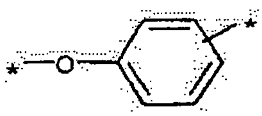

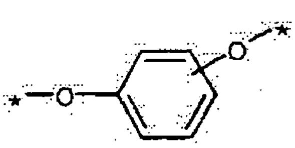

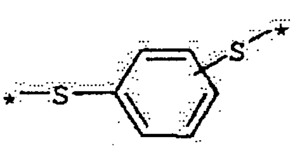

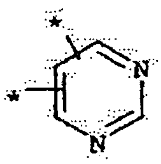

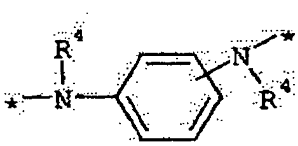

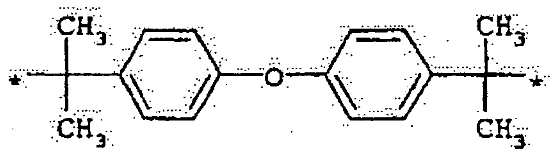

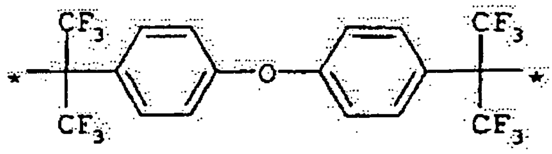

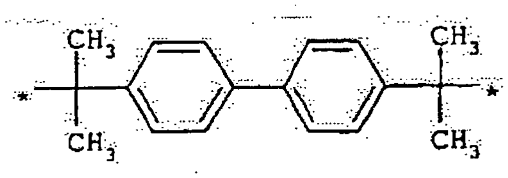

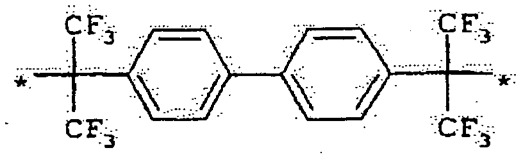
;

$R^4$ :

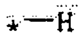

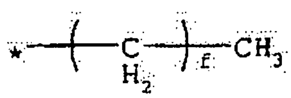

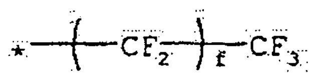

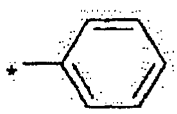

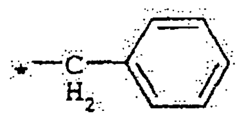
;

$R^5$ : un radical alcoyle, un radical aryle ou un radical hétéroaryle ;

a : 0 ou 1 ;
b : 1 à 200 ;
c : 0 à 200 ;
d : 0 ou 1 ;
e : 0 à 10 ;
f : 0 à 10 ;
g : 0 à 10 ;
h : 1 à 10 ;
n : 0 ou 1 ;

dans laquelle, quand $R^3$= $-CH_2-$, x = 0 à 10 et le modèle de substitution des groupes $Z^1$, $Z^2$ et $Z^3$ est choisi de manière à ce que, respectivement, une paire formée d'un groupe -NH et d'un groupe $OR^1$ soit en position mutuelle ortho.

**2.** Poly-O-hydroxyamides suivant la revendication 1, dans lesquels au moins l'une des conditions suivantes est satisfaite :

b = 5 à 50 ;

c = 0 à 50.

**3.** Poly-O-hydroxyamides suivant la revendication 1 ou 2, dans lesquels :

$$n = 1.$$

**4.** Poly-O-hydroxyamides suivant l'une des revendications précédentes, dans lesquels il est prévu d'autres motifs répétitifs dans le poly-O-hydroxyamide de Formule I qui sont labiles thermiquement et qui dégagent un gaz par chauffage.

**5.** Poly-O-hydroxyamides suivant la revendication 4, dans lesquels les motifs répétitifs labiles thermiquement sont disposés sous forme de segments dans le poly-O-hydroxyamide de Formule I.

**6.** Polybenzoxazole obtenu à partir de poly-O-hydroxyamides suivant l'une des revendications 1 à 5.

**7.** Procédé de préparation de poly-O-hydroxyamides de Formule I, dans lequel on fait réagir au moins un monomère de Formule II

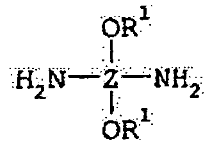

Formule II

dans laquelle Z représente $Z^1$, $Z^2$ ou $Z^3$ et $Z^1$, $Z^2$, $Z^3$ ainsi que $R^1$ ont la signification indiquée à la revendication 1, sur au moins un acide dicarboxylique ou sur un dérivé activé d'acide dicarboxylique de Formule III

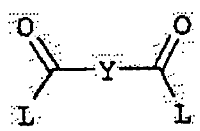

Formule III

L représentant un groupe hydroxy ou un groupe d'activation, Y représentant $Y^1$, $Y^2$ ou $Y^3$ et $Y^1$, $Y^2$, $Y^3$ ayant la signification indiquée à la revendication 1.

**8.** Procédé suivant la revendication 7, dans lequel on effectue la réaction en présence d'une base.

**9.** Procédé de préparation de polybenzoxazoles suivant la revendication 6, dans lequel on chauffe des poly-O-hydroxyamides de Formule I.

**10.** Composant électronique comprenant un diélectrique, qui contient un polybenzoxazole suivant la revendication 6.

**11.** Procédé de production d'un composant électronique suivant la revendication 10, dans lequel on prépare une solution d'un poly-O-hydroxyamide de Formule I dans un solvant, on dépose la solution sur un substrat et on évapore le solvant de manière à obtenir une pellicule, on chauffe la pellicule pour cycliser le poly-O-hydroxyamide de Formule I en le polybenzoxazole suivant la revendication 6 et on structure la pellicule pour obtenir une structure de réserve qui a des sillons et des trous de contact, on dépose sur la structure de réserve une matière conductrice de manière à remplir les sillons et les trous de contact de la matière conductrice et on élimine de la matière conductrice en excès.

**12.** Procédé de production d'un composant électronique suivant la revendication 10, dans lequel on prépare une solution

d'un poly-O-hydroxyamide de Formule I dans un solvant, on dépose la solution sur un substrat qui a sur sa surface des structures métalliques entre lesquelles sont disposés des sillons et des trous de contact, on évapore le solvant de manière à remplir les sillons et les trous de contact du poly-O-hydroxyamide de Formule I et on chauffe le substrat pour cycliser le poly-O-hydroxyamide de Formule I en le polybenzoxazole suivant la revendication 6.

**13.** Procédé suivant l'une des revendications 11 ou 12, dans lequel on ajoute un agent porogène à la solution du poly-O-hydroxy amide de Formule I.

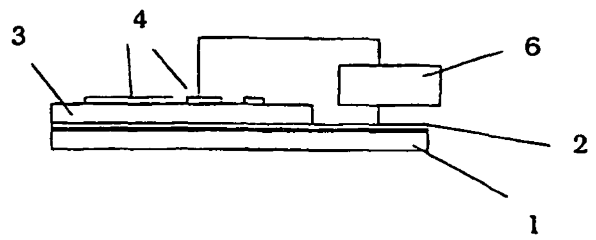


Fig. 1

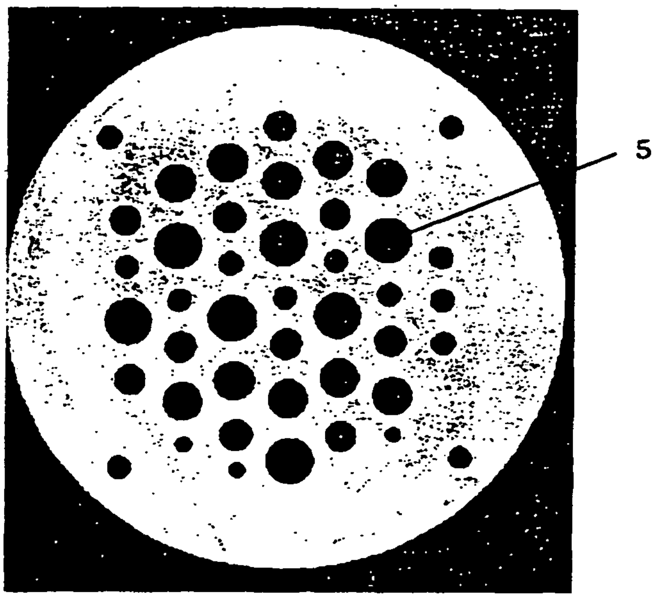


Fig. 2